# EUROPEAN PATENT APPLICATION

(11) **EP 4 432 804 A1**
(43) Date of publication of application: **18.09.2024**
(21) Application number: 23211159.1
(22) Date of filing: 21.11.2023
(51) Int. Cl.: H10B 41/10, H10B 41/27, H10B 41/50, H10B 43/10, H10B 43/27, H10B 43/50

(54) **SEMICONDUCTOR DEVICE, ELECTRONIC SYSTEM INCLUDING THE SAME, AND METHOD OF FABRICATING THE SAME**

(30) Priority: 17.03.2023 KR 20230035461
(71) Applicant: Samsung Electronics Co., Ltd., Suwon-si, Gyeonggi-do 16677 (KR)
(72) Inventor: LEE, Ahreum, 16677 Suwon-si (KR); YANG, Woosung, 16677 Suwon-si (KR); GU, Jimo, 16677 Suwon-si (KR); SUNG, Sukkang, 16677 Suwon-si (KR)
(74) Representative: Marks & Clerk LLP

(57) **Abstract**

Disclosed are semiconductor devices which may include a substrate having first and second regions, a stack structure including electrode patterns and dielectric patterns, channels vertically penetrating the stack structure on the first region, a planarized dielectric layer covering the stack structure, and wiring patterns on the planarized dielectric layer. The dielectric pattern includes a first dielectric pattern on the first region, and a second dielectric pattern on the second region. The second dielectric pattern includes a first sub-dielectric pattern and a second sub-dielectric pattern. A dielectric constant of the first sub-dielectric patterns is greater than that of the first dielectric patterns and that of the second sub-dielectric patterns.

## Description

### BACKGROUND

The present invention relates to a semiconductor device. The disclosure further discusses electronic systems including the same.

Semiconductor devices have been highly integrated to meet high performance and low manufacturing cost which are required by customers. Because integration of the semiconductor devices is an important factor in determining product price, high integration is increasingly requested. Integration of typical two-dimensional or planar semiconductor devices is primarily determined by the area occupied by a unit memory cell, such that it is greatly influenced by the level of technology for forming fine patterns. However, the extremely expensive processing equipment needed to increase pattern fineness may set a practical limitation on increasing the integration of the two-dimensional or planar semiconductor devices. Therefore, there have been proposed three-dimensional semiconductor devices having three-dimensionally arranged memory cells.

### SUMMARY

According to the present invention, there is provided a semiconductor device comprising: a substrate including a first region and a second region in a first direction from the first region; a stack structure including electrode patterns and dielectric patterns vertically and alternately stacked on the substrate; a plurality of channels vertically penetrating the stack structure on the first region; a planarized dielectric layer covering the stack structure; and a plurality of wiring patterns on the planarized dielectric layer, each of the dielectric patterns including: a first dielectric pattern on the first region; and a second dielectric pattern on the second region, each of the second dielectric patterns including: a first sub-dielectric pattern; and a second sub-dielectric pattern connected in a second direction to the first sub-dielectric pattern, the second direction intersecting the first direction, wherein a dielectric constant of the first sub-dielectric patterns is greater than a dielectric constant of the first dielectric patterns and a dielectric constant of the second sub-dielectric patterns.

Preferred embodiments are defined by the dependent claims.

It is noted that 'includes' and `including ` generally mean 'comprises at least' or `comprising at least' respectively. 'Lowermost' generally means nearest the substrate.

### BRIEF DESCRIPTION OF DRAWINGS

Example embodiments will be more clearly understood from the following detailed description taken in conjunction with the accompanying drawings.
FIG. 1 illustrates a simplified block diagram showing an electronic system including a semiconductor device according to embodiments.
FIG. 2 illustrates a simplified perspective view showing an electronic system including a semiconductor device according to embodiments.
FIGS. 3 and 4 illustrate simplified cross-sectional views showing a semiconductor package according to embodiments.
FIG. 5 illustrates a simplified perspective view showing a semiconductor device according to embodiments.
FIG. 6 illustrates a circuit diagram showing a cell array of a semiconductor device according to embodiments.
FIGS. 7 and 8 illustrate simplified plan views showing a semiconductor device according to embodiments.
FIG. 9 illustrates a plan view showing a semiconductor device according to embodiments.
FIGS. 10A and 10B illustrate cross-sectional views showing a semiconductor device according to embodiments.
FIGS. 11 and 12 illustrate enlarged cross-sectional views showing section A of FIG. 10B.
FIGS. 13 to 15 illustrate cross-sectional views showing a semiconductor device according to embodiments.
FIGS. 16A to 19A and 16B to 19B illustrate cross-sectional views showing a semiconductor device according to embodiments.
FIG. 20 illustrates a cross-sectional view showing a semiconductor device according to embodiments.
FIGS. 21A to 29A and 21B to 29B illustrate cross-sectional views showing a method of fabricating a semiconductor device according to embodiments.

### DETAILED DESCRIPTION OF EMBODIMENTS

Some example embodiments of the present inventive concept provide semiconductor devices with increased electrical properties.

An embodiment comprises a substrate including a first region and a second region positioned in a first direction from the first region; a stack structure that includes electrode patterns and dielectric patterns that are vertically and alternately stacked on the substrate; a plurality of channels that vertically penetrate the stack structure on the first region; a planarized dielectric layer that covers the stack structure; and a plurality of wiring patterns on the planarized dielectric layer. Each of the dielectric patterns includes a first dielectric pattern on the first region; and a second dielectric pattern on the second region. Each of the second dielectric patterns includes a first sub-dielectric pattern; and a second sub-dielectric pattern connected in a second direction to the first sub-dielectric pattern, the second direction intersecting the first direction. A dielectric constant of the first sub-dielectric patterns is greater than a dielectric constant of the first dielectric patterns and a dielectric constant of the second sub-dielectric patterns.

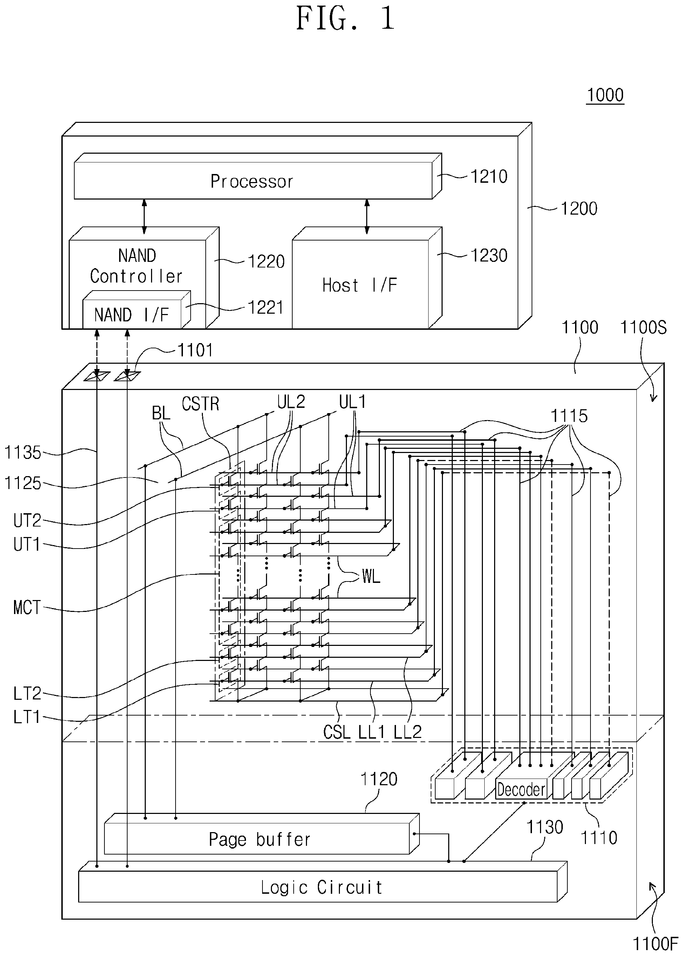

FIG. 1 illustrates a simplified block diagram showing an electronic system including a semiconductor device according to some example embodiments of the present inventive concept.

Referring to FIG. 1, an electronic system 1000 may include a semiconductor device 1100 and a controller 1200 electrically connected to the semiconductor device 1100. The electronic system 1000 may be a storage apparatus including a single or a plurality of semiconductor devices 1100 or an electronic apparatus including the storage apparatus. For example, the electronic system 1000 may be a solid state drive (SSD) device, a universal serial bus (USB), a computing system, a medical apparatus, or a communication apparatus, each of which includes a single or a plurality of semiconductor devices 1100.

The semiconductor device 1100 may be a nonvolatile memory device, such as a NAND Flash memory device. The semiconductor device 1100 may include a first structure 1100F and a second structure 1100S on the first structure 1100F. The first structure 1100F may be disposed on a side of the second structure 1100S. The first structure 1100F may be a peripheral circuit structure that includes a decoder circuit 1110, a page buffer 1120, and a logic circuit 1130. The second structure 1100S may be a memory cell structure that includes a bit line BL, a common source line CSL, word lines WL, first and second gate upper lines UL1 and UL2, first and second gate lower lines LL1 and LL2, and memory cell strings CSTR between the bit line BL and the common source line CSL.

In the second structure 1100S, each of the memory cell strings CSTR may include lower transistors LT1 and LT2 adjacent to the common source line CSL, upper transistors UT1 and UT2 adjacent to the bit line BL, and memory cell transistors MCT disposed between the lower transistors LT1 and LT2 and the upper transistors UT1 and UT2. The number of the lower transistors LT1 and LT2 and of the upper transistors UT1 and UT2 may be variously changed in accordance with example embodiments.

The upper transistors UT1 and UT2 may include string selection transistors, and the lower transistors LT1 and LT2 may include ground selection transistors. The gate lower lines LL1 and LL2 may be gate electrodes of the lower transistors LT1 and LT2, respectively. The word lines WL may be gate electrodes of the memory cell transistors MCT, and the gate upper lines UL1 and UL2 may be gate electrodes of the upper transistors UT1 and UT2, respectively.

The lower transistors LT1 and LT2 may include a lower erase control transistor LT1 and a ground selection transistor LT2 that are connected in series. The upper transistors UT1 and UT2 may include a string selection transistor UT1 and an upper erase control transistor UT2 that are connected in series. One or both of the lower and upper erase control transistors LT1 and UT1 may be employed to perform an erase operation in which a gate induced drain leakage (GIDL) phenomenon is used to erase data stored in the memory cell transistors MCT.

The common source line CSL, the first and second gate lower lines LL1 and LL2, the word lines WL, and the first and second gate upper lines UL1 and UL2 may be electrically connected to the decoder circuit 1110 through first connection lines 1115 that extend from the first structure 1100F toward the second structure 1100S. The bit lines BL may be electrically connected to the page buffer 1120 through second connection lines 1125 that extend from the first structure 1100F toward the second structure 1100S.

In the first structure 1100F, the decoder circuit 1110 and the page buffer 1120 may perform a control operation on at least one selection memory cell transistor among the plurality of memory cell transistors MCT. The logic circuit 1130 may control the decoder circuit 1110 and the page buffer 1120. The electronic system 1000 may communicate with the controller 1200 through input/output pads 1101 electrically connected to the logic circuit 1130. The input/output pad 1101 may be electrically connected to the logic circuit 1130 through an input/output connection line 1135 that extends from the first structure 1100F toward the second structure 1100S.

The controller 1200 may include a processor 1210, a NAND controller 1220, and a host interface 1230. In some example embodiments, the electronic system 1000 may include a plurality of semiconductor devices 1100, and in this case, the controller 1200 may control the plurality of semiconductor devices 1100.

The processor 1210 may control an operation of the electronic system 1000 that includes the controller 1200. The processor 1210 may operate based on predetermined (or, alternatively, desired or selected, etc.) firmware, and may control the NAND controller 1220 to access the semiconductor device 1100. The NAND controller 1220 may include a NAND interface 1221 that processes communication with the semiconductor device 1100. The NAND interface 1221 may be used to transfer therethrough a control command to control the semiconductor device 1100, data intended to be written on the memory cell transistors MCT of the semiconductor device 1100, and/or data intended to be read from the memory cell transistors MCT of the semiconductor device 1100. The host interface 1230 may provide the electronic system 1000 with communication with an external host. When a control command is received through the host interface 1230 from an external host, the semiconductor device 1100 may be controlled by the processor 1210 in response to the control command.

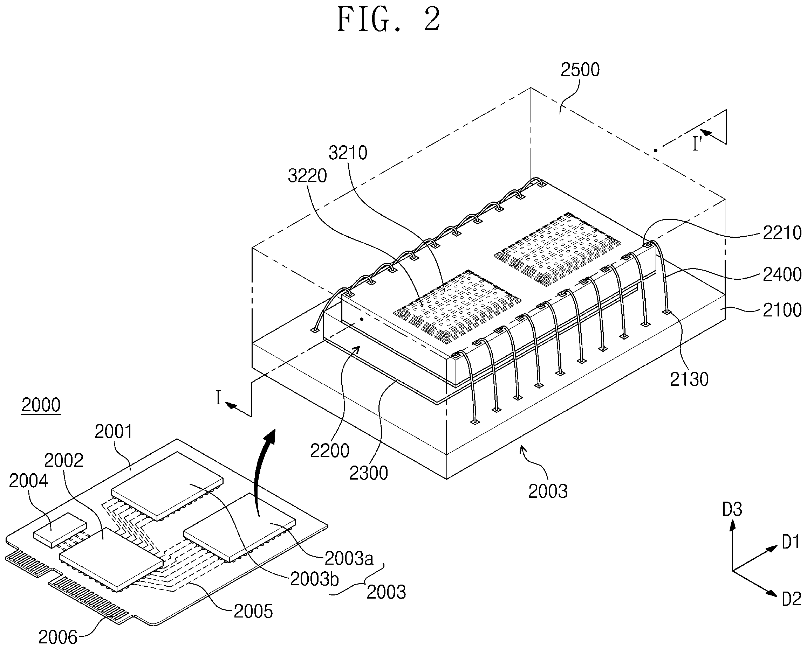

FIG. 2 illustrates a simplified perspective view showing an electronic system that includes a semiconductor device according to some example embodiments of the present inventive concept.

Referring to FIG. 2, an electronic system 2000 may include a main board 2001, a controller 2002 mounted on the main board 2001, at least one semiconductor package 2003, and a dynamic random access memory (DRAM) 2004. The semiconductor package 2003 and the DRAM 2004 may be connected to the controller 2002 through wiring patterns 2005 formed on the main board 2001.

The main board 2001 may include a connector 2006 including a plurality of pins that are coupled to an external host. The number and arrangement of the plurality of pins in the connector 2006 may be changed based on a communication interface between the electronic system 2000 and the external host. In some example embodiments, the electronic system 2000 may communicate with the external host through one or more interfaces, for example, universal serial bus (USB), peripheral component interconnect express (PIC-Express), serial advanced technology attachment (SATA), and M-PHY for universal flash storage (UFS). For example, the electronic system 2000 may operate with power supplied through the connector 2006 from the external host. The electronic system 2000 may further include a power management integrated circuit (PMIC) by which the power supplied from the external host is distributed to the controller 2002 and the semiconductor package 2003.

The controller 2002 may write data to the semiconductor package 2003, may read data from the semiconductor package 2003, or may increase an operating speed of the electronic system 2000.

The DRAM 2004 may be a buffer memory that reduces a difference in speed between the external host and the semiconductor package 2003 that serves as a data storage space. The DRAM 2004 included in the electronic system 2000 may operate as a kind of cache memory, and may provide a space for temporary data storage in a control operation of the semiconductor package 2003. When the DRAM 2004 is included in the electronic system 2000, the controller 2002 may include not only a NAND controller for controlling the semiconductor package 2003, but also a DRAM controller for controlling the DRAM 2004.

The semiconductor package 2003 may include first and second semiconductor packages 2003a and 2003b that are spaced apart from each other. Each of the first and second semiconductor packages 2003a and 2003b may include a plurality of semiconductor chips 2200. Each of the first and second semiconductor packages 2003a and 2003b may include a package substrate 2100, semiconductor chips 2200 on the package substrate 2100, adhesion layers 2300 disposed on bottom surfaces of the semiconductor chips 2200, connection structures 2400 that electrically connect the semiconductor chips 2200 to the package substrate 2100, and a molding layer 2500 that covers the semiconductor chips 2200 and the connection structures 2400 on the package substrate 2100.

The package substrate 2100 may be an integrated circuit board including package upper pads 2130. Each of the semiconductor chips 2200 may include one or more input/output pads 2210. The input/output pad 2210 may correspond to the input/output pad 1101 of FIG. 1. Each of the semiconductor chips 2200 may include stack structures 3210 and vertical structures 3220. Each of the semiconductor chips 2200 may include a semiconductor device according to some example embodiments of the present inventive concept which will be discussed below.

The connection structures 2400 may be bonding wires that electrically connect the input/output pads 2210 to the package upper pads 2130. Therefore, in each of the first and second semiconductor packages 2003a and 2003b, the semiconductor chips 2200 may be electrically connected to each other in a wire bonding manner, and may be electrically connected to the package upper pads 2130 of the package substrate 2100. In each of the first and second semiconductor packages 2003a and 2003b, the semiconductor chips 2200 may be electrically connected to each other through a connection structure including though electrodes instead of the connection structures 2400 shaped like bonding wires.

The controller 2002 and the semiconductor chips 2200 may be included in one package. The controller 2002 and the semiconductor chips 2200 may be mounted on an interposer substrate other than the main board 2001, and may be connected to each other through wiring lines provided in the interposer substrate.

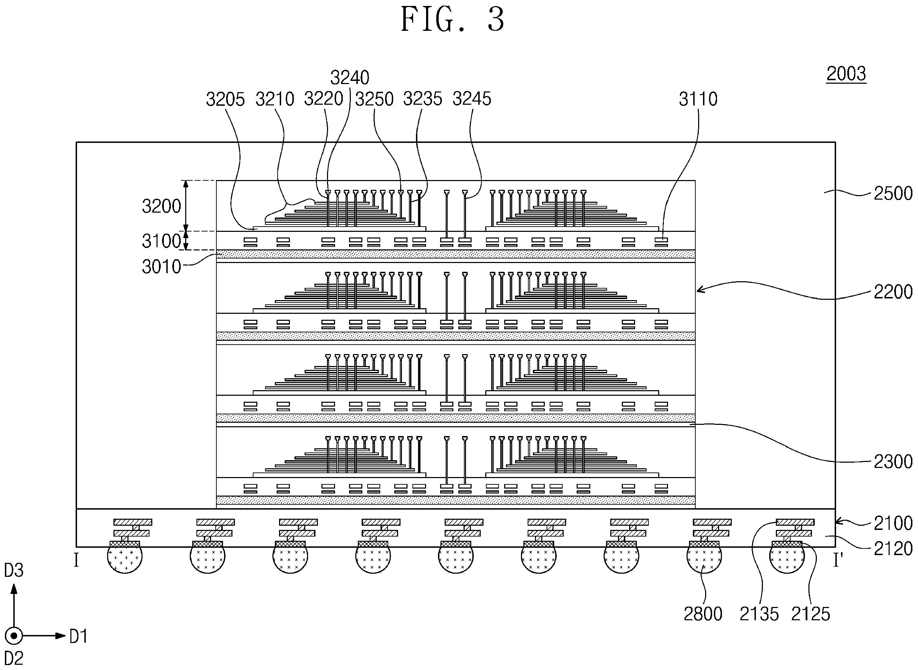

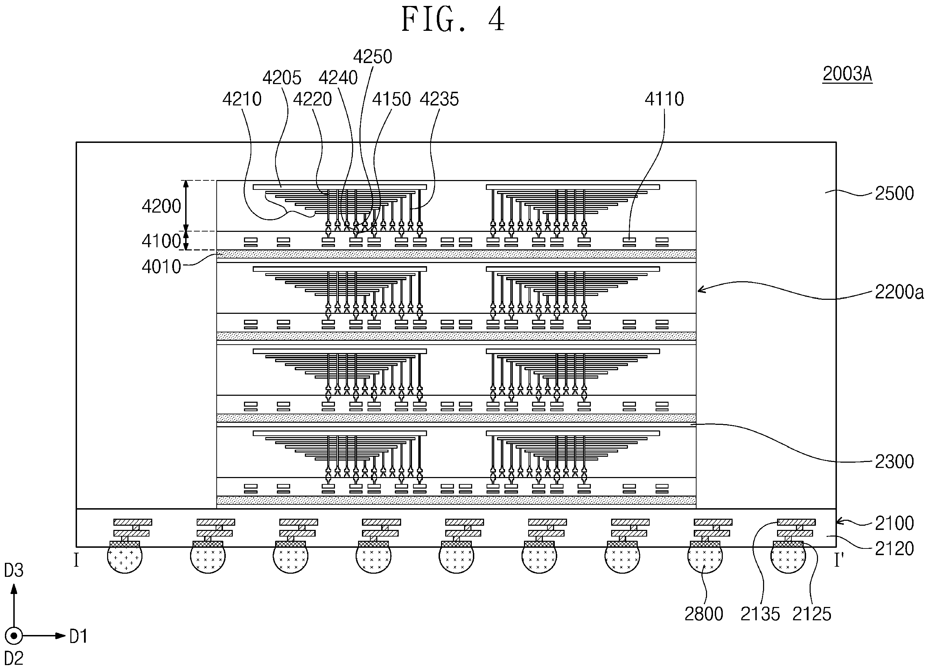

FIGS. 3 and 4 illustrate simplified cross-sectional views showing a semiconductor package according to some example embodiments of the present inventive concept.

FIGS. 3 and 4 each depicts an example of the semiconductor package illustrated in FIG. 2, conceptually showing a section taken along line I-I' of the semiconductor package illustrated in FIG. 2. Referring to FIG. 3, a printed circuit board may be used as the package substrate 2100 of the semiconductor package 2003. The package substrate 2100 may include a package substrate body 2120, package upper pads (see package upper pads 2130 of FIG. 2) disposed on a top surface of the package substrate body 2120, lower pads 2125 disposed or exposed on a bottom surface of the package substrate body 2120, and internal lines 2135 that lie in the package substrate body 2120 and electrically connect the upper pads 2130 to the lower pads 2125. The upper pads 2130 may be electrically connected to the connection structures 2400. The lower pads 2125 may be connected through conductive connectors 2800 to the wiring patterns 2005 of the main board 2001 in the electronic system 2000, as shown in FIG. 2.

Each of the semiconductor chips 2200 may include a semiconductor substrate 3010, and may also include a first structure 3100 and a second structure 3200 that are sequentially stacked on the semiconductor substrate 3010. The first structure 3100 may include a peripheral circuit region including peripheral wiring lines 3110. The second structure 3200 may include a source structure 3205, a stack structure 3210 on the source structure 3205, vertical structures 3220 and separation structures each of which penetrates the stack structure 3210, bit lines 3240 electrically connected to the vertical structures 3220, and cell contact plugs 3235 electrically connected to word lines (see word lines WL of FIG. 1) of the stack structure 3210. The first and second structures 3100 and 3200 and the semiconductor chips 2200 may each further include separation structures which will be discussed below.

Each of the semiconductor chips 2200 may include one or more through wiring lines 3245 that extend into the second structure 3200 and are electrically connected to the peripheral wiring lines 3110 of the first structure 3100. The through line 3245 may be disposed outside the stack structure 3210 and may further be disposed to penetrate the stack structure 3210. Each of the semiconductor chips 2200 may further include one or more input/output pads (see input/output pads 2210 of FIG. 2) electrically connected to the peripheral wiring lines 3110 of the first structure 3100.

Referring to FIG. 4, a semiconductor package 2003A may be configured such that each of semiconductor chips 2200a may include a semiconductor substrate 4010, a first structure 4100 on the semiconductor substrate 4010, and a second structure 4200 disposed on and wafer-bonded to the first structure 4100.

The first structure 4100 may include a peripheral circuit region including peripheral wiring lines 4110 and first bonding structures 4150. The second structure 4200 may include a source structure 4205, a stack structure 4210 between the source structure 4205 and the first structure 4100, vertical structures 4220 and separation structures each of which penetrates the stack structure 4210, and second bonding structures 4250 electrically connected to the vertical structures 4220 and word lines (see word lines WL of FIG. 1) of the stack structure 4210. For example, the second bonding structures 4250 may be electrically connected to the vertical structures 4220 and the word lines WL through bit lines 4240 electrically connected to the vertical structures 4220 and through cell contact plugs 4235 electrically connected to the word lines WL. The first bonding structures 4150 of the first structure 4100 and the second bonding structures 4250 of the second structure 4200 may be bonded to each other while being in contact with each other. The first and second bonding structures 4150 and 4250 may have their bonding portions that are formed of, for example, copper.

The first structure 4100, the second structure 4200, and the semiconductor chip 2200a may each further include a source structure according to some example embodiments which will be discussed below. Each of the semiconductor chips 2200a may further include one or more input/output pads (see input/output pad 2210 of FIG. 2) electrically connected to the peripheral wiring lines 4110 of the first structure 4100.

The semiconductor chips 2200 of FIG. 3 may be electrically connected to each other through the connection structures 2400 shaped like bonding wires, and this may also be applicable to the semiconductor chips 2200a of FIG. 4. Alternatively, a connection structure, for example, a through electrode (TSV), may be used to electrically connect to each other semiconductor chips, such as the semiconductor chips 2200 of FIG. 3 and the semiconductor chips 2200a of FIG. 4, in one semiconductor package.

The first structure 3100 of FIG. 3 and the first structure 4100 of FIG. 4 may correspond to a peripheral circuit structure in the following example embodiments, and the second structure 4200 of FIG. 3 and the second structure 4200 of FIG. 4 may correspond to a cell array structure in the following example embodiments.

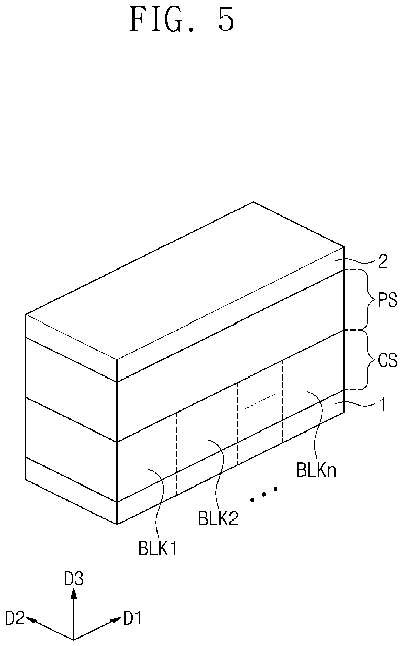

FIG. 5 illustrates a simplified cross-sectional view showing a semiconductor device according to some example embodiments of the present inventive concept.

Referring to FIG. 5, a three-dimensional semiconductor device may include a peripheral circuit structure PS and a cell array structure CS on which the peripheral circuit structure PS is stacked. For example, the cell array structure CS and the peripheral circuit structure PS may overlap each other in plan view. The peripheral circuit structure PS integrated on a second substrate 2 may be stacked on the cell array structure CS integrated on a first substrate 1, and in this case, the cell array structure CS and the peripheral circuit structure PS may be in contact with each other.

The cell array structure CS may include a cell array including a plurality of three-dimensionally arranged memory cells. The cell array may be integrated on the first substrate 1.

The cell array structure CS may include one or more mats, and each of the mats may include a plurality of memory blocks BLK1 to BLKn. Each of the memory blocks BLK1 to BLKn may include three-dimensionally arranged memory cells. For example, each of the memory blocks BLK1 to BLKn may include structures that are stacked along a third direction D3 on the first substrate 1.

The peripheral circuit structure PS may include a row decoder, a column decoder, a page buffer, and a control circuit that control the cell array. The second substrate 2 may be provided thereon with integrated peripheral logic circuits that constitute the peripheral circuit structure PS.

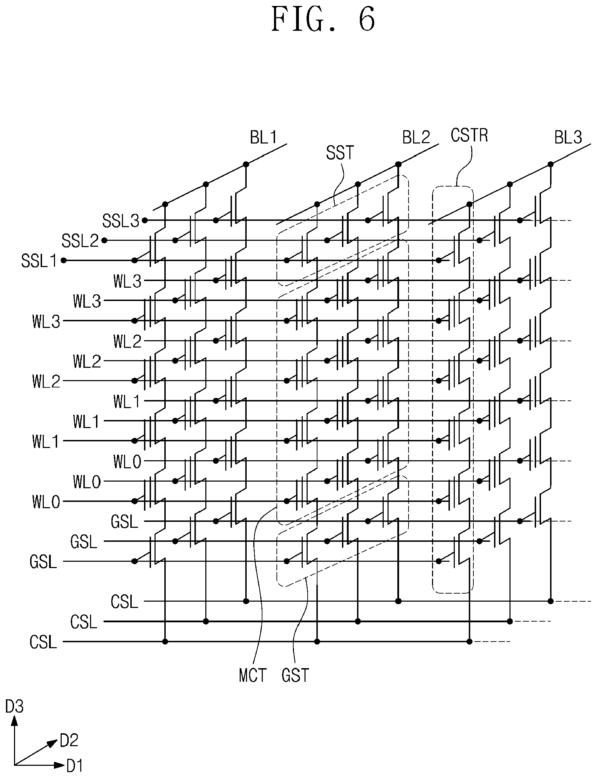

FIG. 6 illustrates a circuit diagram showing a cell array of a semiconductor device according to some example embodiments of the present inventive concept.

Referring to FIG. 6, a three-dimensional semiconductor device may be a three-dimensional NAND Flash memory device. A cell array of the three-dimensional NAND Flash memory device may include a common source line CSL, a plurality of bit lines BL1 to BL3, and a plurality of cell strings CSTR between the common source line CSL and the bit lines BL1 to BL3. The cell strings CSTR may extend along a third direction D3 perpendicular to first and second directions D1 and D2.

The bit lines BL1 to BL3 may be two-dimensionally arranged, and a plurality of cell strings CSTR may be connected in parallel to each of the bit lines BL1 to BL3. The cell strings CSTR may be connected in common to the common source line CSL. For example, a plurality of cell strings CSTR may be disposed between a plurality of bit lines BL1 to BL3 and one common source line CSL. The common source line CSL may be provided in plural arranged two-dimensionally. In this configuration, the common source lines CSL may be supplied with the same or similar voltage or may be electrically controlled independently of each other.

Each of the cell strings CSTR may include a ground selection transistor GST coupled to the common source line CSL, a string selection transistor SST coupled to one of the bit lines BL1 to BL3, and a plurality of memory cell transistors MCT disposed between the ground and string selection transistors GST and SST. The ground selection transistor GST, the string selection transistor SST, and the memory cell transistors MCT may be connected in series. The common source line CSL may be connected in common to sources of the ground selection transistors GST.

A ground selection line GSL, a plurality of word lines WL0 to WL3, and a plurality of string selection lines SSL1 to SSL3 between the common source line CSL and the bit lines BL1 to BL3 may be used as gate electrodes of the ground selection transistor GST, the memory cell transistors MCT, and the string selection transistor SST, respectively. In addition, each of the memory cell transistors MCT may include a data storage element.

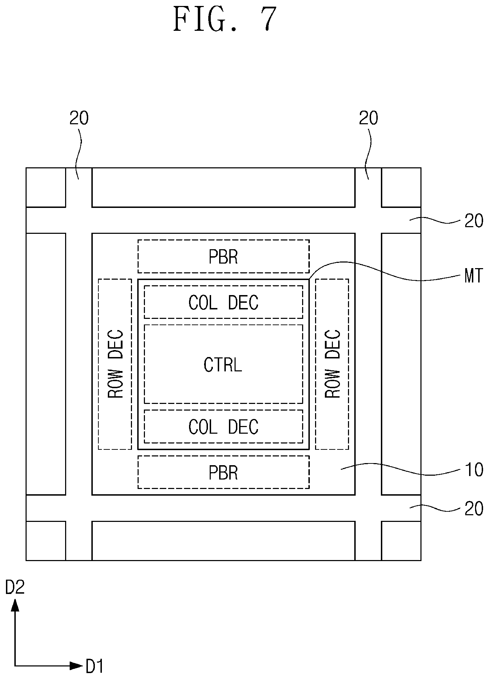

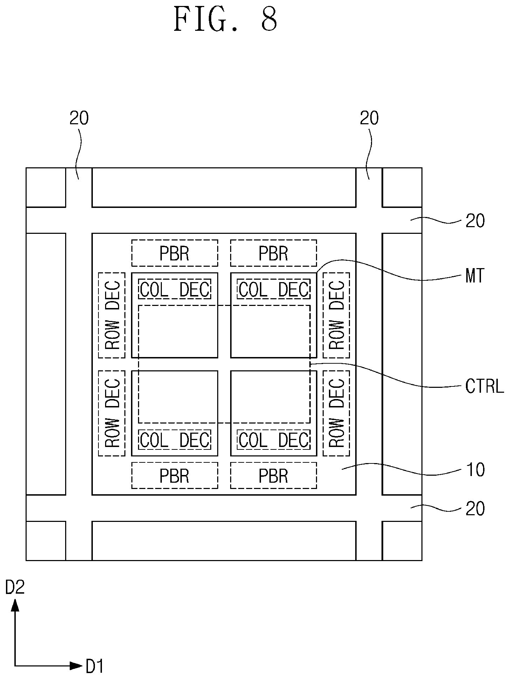

FIGS. 7 and 8 illustrate simplified plan views showing a semiconductor device according to some example embodiments of the present inventive concept.

Referring to FIGS. 7 and 8, chip regions 10 of the second substrate 2 including the peripheral circuit structure PS may be correspondingly disposed on chip regions 10 of the first substrate 1 including the cell array structure CS.

On each of the chip regions 10, the second substrate 2 may be provided thereon with the peripheral circuit structure PS that includes row decoders ROW DEC, column decoders COL DEC, page buffers PBR, and a control circuit CTRL. The chip regions 10 may be surrounded by a scribe line region 20, and the scribe line region 20 may be used for singulation of three-dimensional semiconductor devices when a sawing process is performed in fabricating three-dimensional semiconductor devices.

Referring to FIG. 7, on each of the chip regions 10, one mat MT or one block may be disposed to constitute the cell array structure (see cell array structure CS of FIG. 5). The mat MT may be provided on the first substrate (see substrate 1 of FIG. 5). One mat MT may be disposed to overlap a portion of the peripheral circuit structure (see peripheral circuit structure PS of FIG. 5). For example, in plan view, the row decoders ROW DEC and the page buffers PBR may be disposed around the mat MT. The column decoders COL DEC and the control circuit CTRL may overlap the mat MT. According to some example embodiments, peripheral circuits included in the peripheral circuit structure (see peripheral circuit structure PS of FIG. 5) may be freely or arbitrarily disposed on the mat MT.

Referring to FIG. 8, each chip region 10 may be provided thereon with a plurality of mats MT or a plurality of blocks included in the cell array structure (see cell array structure CS of FIG. 5). The plurality of mats MT may be arranged along a first direction D 1 and a second direction D2. The plurality of mats MT may be provided on the first substrate (see substrate 1 of FIG. 5).

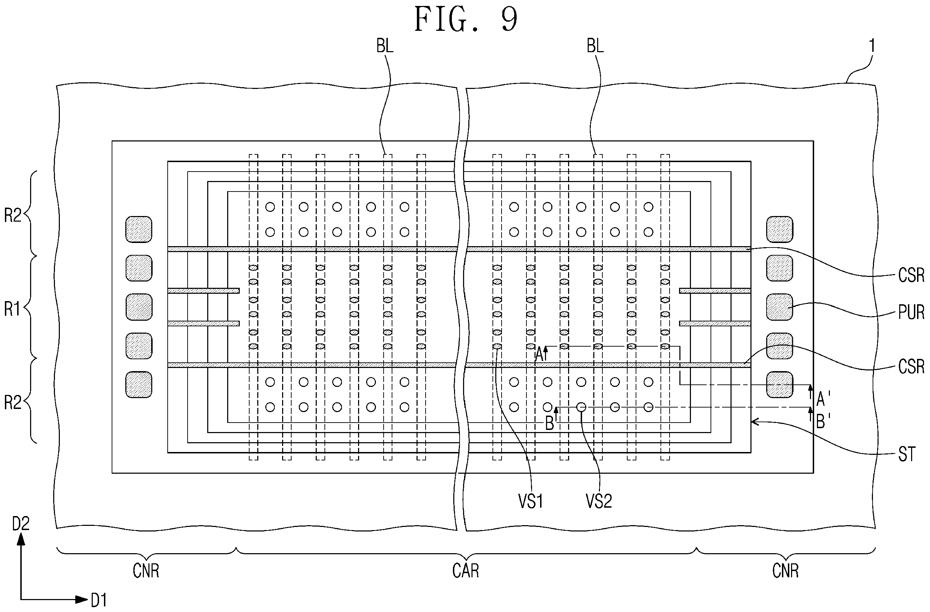

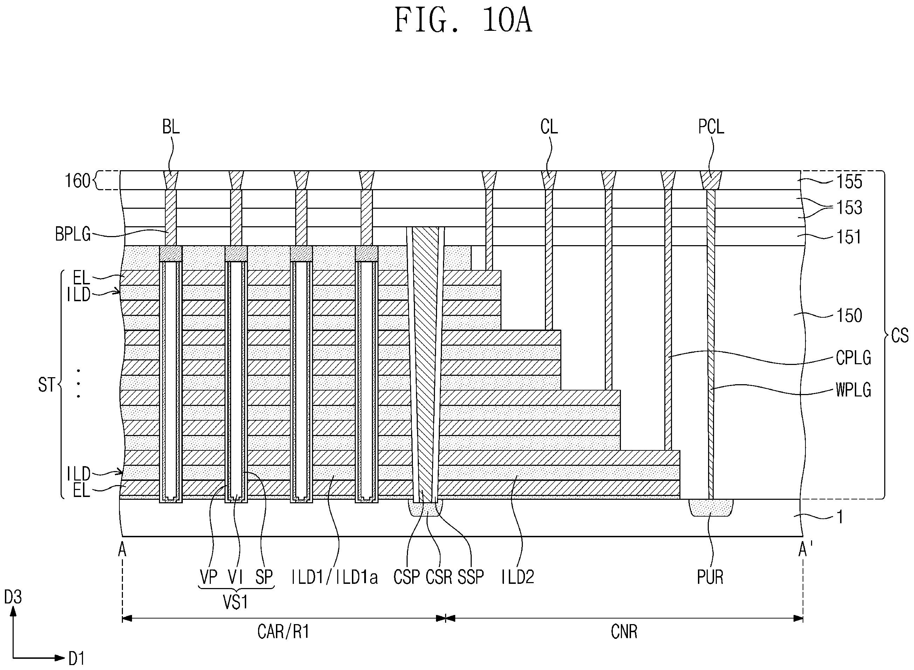

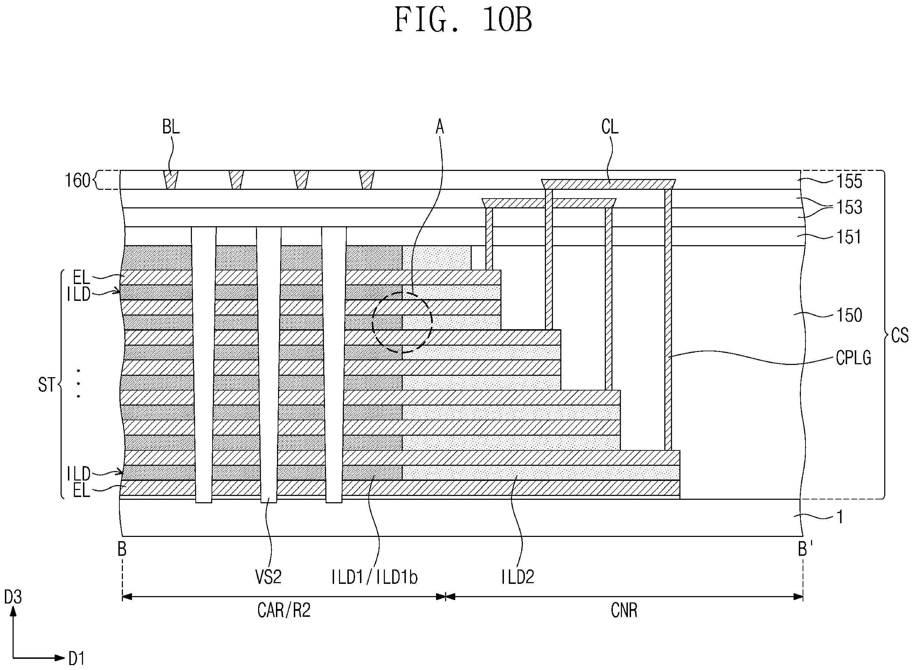

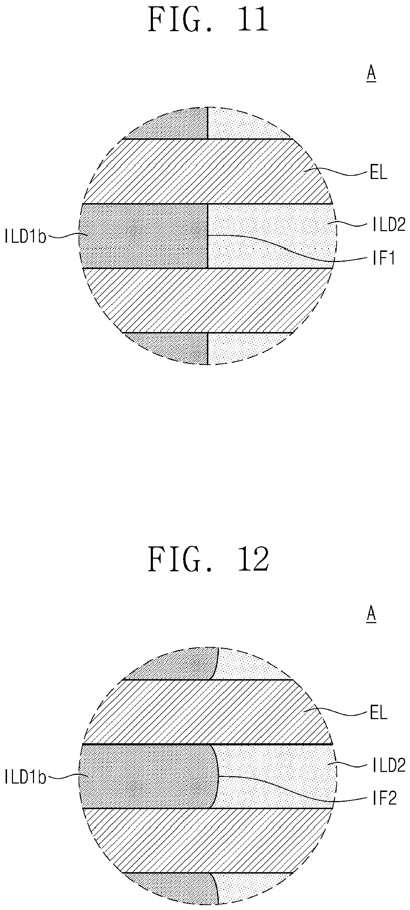

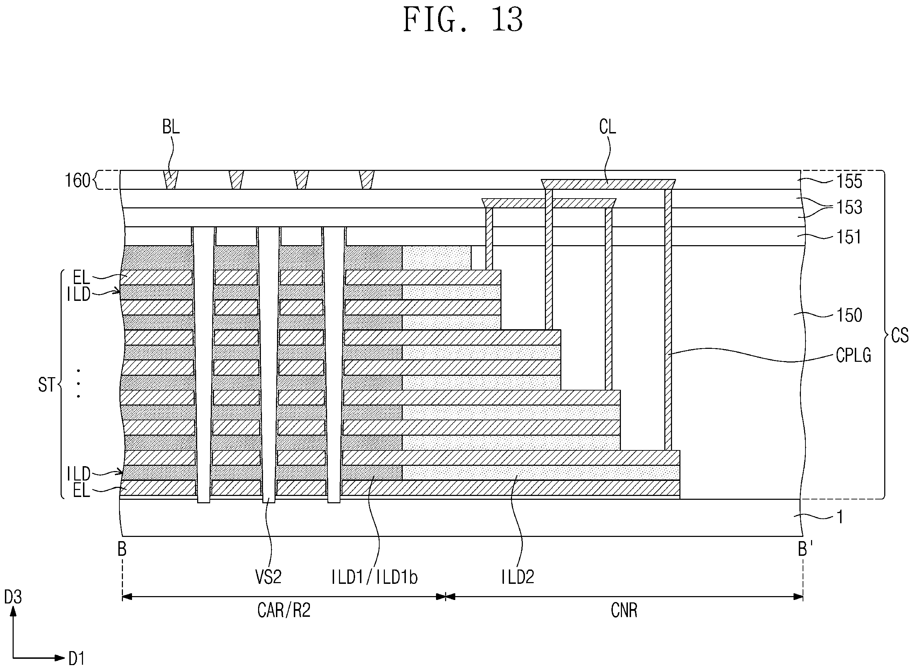

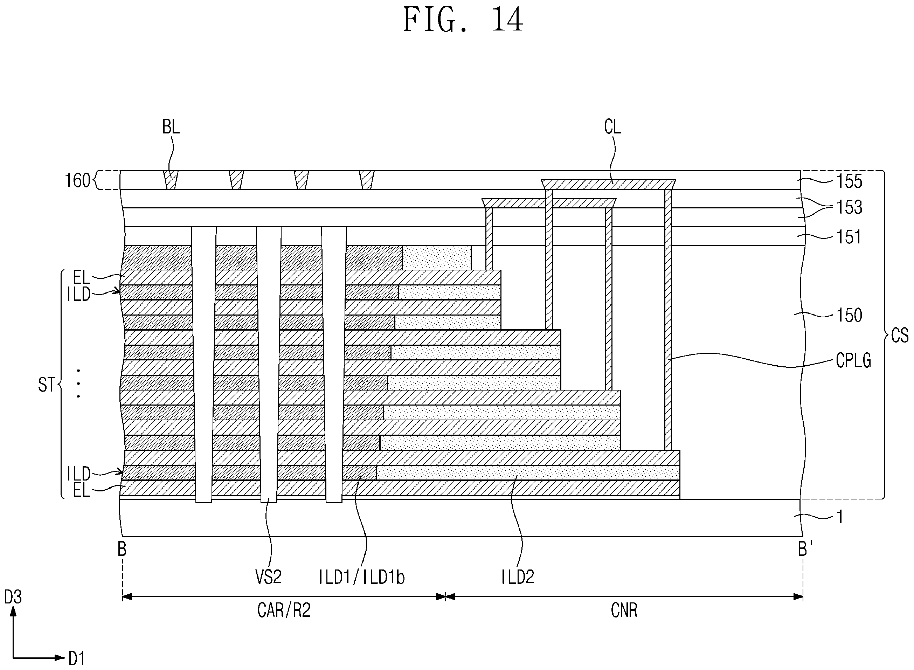

FIG. 9 illustrates a plan view showing a semiconductor device according to some example embodiments of the present inventive concept. FIGS. 10A and 10B illustrate cross-sectional views respectively taken along lines A-A' and B-B' of FIG. 9, showing a semiconductor device according to some example embodiments of the present inventive concept. FIGS. 11 and 12 illustrate enlarged cross-sectional views showing section A of FIG. 10B. FIGS. 13 and 14 illustrate cross-sectional views taken along line B-B' of FIG. 9, showing a semiconductor device according to some example embodiments of the present inventive concept.

Referring to FIGS. 9, 10A, and 10B, a first substrate 1 may be provided. The first substrate 1 may be formed of a semiconductor material and may be, for example, a silicon (Si) substrate, a silicon-germanium (SiGe) substrate, or a single-crystalline epitaxial layer grown on a single-crystalline silicon (Si) substrate. For example, the first substrate 1 may be a silicon (Si) substrate. Additionally or alternatively, the first substrate 1 may include a semiconductor doped with impurities having a first conductivity type (e.g., p-type) or an intrinsic semiconductor doped with no impurities. The first substrate 1 may have a single-crystalline structure, an amorphous structure, or a polycrystalline structure. The first substrate 1 may include a cell array region CAR and a connection region CNR around the cell array region CAR. For convenience of description, the following will describe an example shown in FIGS. 10A and 10B in which the connection region CNR is disposed in a first direction D1 of the cell array region CAR. Embodiments of the present inventive concept, however, are not limited thereto, and for example as discussed above, the connection region CNR may surround the cell array region CAR in plan view. The cell array region CAR may have a first region R1 and a second region R2 that are distinguished from each other. The second region R2 may be positioned in a second direction D2 or its opposite direction of the first region R1. The first region R1 may be a zone on which are provided a plurality of three-dimensionally arranged memory cells, and the second region R2 may be a residual area on which no memory cells are provided. The second region R2 may be provided thereon with capacitors. FIG. 9 depicts that, compared to the first region R1, the second region R2 is positioned on an outer portion on the first substrate 1, but the present inventive concept is not limited thereto. According to some example embodiments, compared to the second region R2, the first region R1 may be positioned on an outer portion on the first substrate 1. The first and second regions R1 and R2 may be divided, for example by the common source region CSR. In some example embodiments, the common source region may be included in the first region R1, with an outer boundary of the common source region CSR defining the interface between the first and second regions R1 and R2.The following description will relate to the example embodiments of FIG. 9.

A cell array structure CS may be provided on the first substrate 1, and may include a stack structure ST, first vertical structures VS 1, and connection structures CPLG, CL, WPLG, and PCL.

The stack structure ST may extend along the first direction D1 from the cell array region CAR toward the connection region CNR, and may have a stepwise structure on the connection region CNR. The stack structure ST may have variously shaped stepwise structures on the connection region CNR. The stack structure ST may include electrode patterns EL that are vertically stacked on the first substrate 1 and dielectric patterns ILD interposed between the electrode patterns EL.

The electrode patterns EL of the stack structure ST may have lengths in the first direction D1 that decrease with increasing distance from the first substrate 1. The electrode patterns EL may include a conductive material the same or similar as that of at least one selected from a semiconductor layer, a metal silicide layer, a metal layer, a metal nitride layer, and a multiple layer including a combination thereof.

The electrode patterns EL provided on the first region R1 of the cell array region CAR may be gate electrodes of transistors provided on the stack structure ST. In some example embodiments, a semiconductor device may be a three-dimensional NAND Flash memory device, and the cell strings CSTR of FIG. 6 may be integrated on the first substrate 1. In this case, the stack structure ST on the cell array region CAR may be configured such that uppermost and lowermost electrode patterns EL may be used as gate electrodes of selection transistors (see transistors SST and GST of FIG. 6). For example, the uppermost electrode pattern EL may be used as a gate electrode of the string selection transistor SST that controls an electrical connection between a bit line BL and the first vertical structures VS 1, and the lowermost electrode pattern EL may be used as a gate electrode of the ground selection transistor GST that controls an electrical connection between a common source line CSL and the first vertical structures VS 1. The electrode patterns EL between the uppermost and lowermost electrode patterns EL may be used as control gate electrodes of memory cells and as word lines (see word lines WL0 to WL3 of FIG. 6) that connect the control gate electrodes to each other. The electrode patterns EL provided on the second region R2 of the cell array region CAR may be electrodes of capacitors provided on the stack structure ST.

The dielectric patterns ILD of the stack structure ST may have lengths in the first direction D1 that decrease with increasing distance from the first substrate 1. Each of the dielectric patterns ILD may have the same or similar length as that of its overlying one of the electrode patterns EL. The dielectric patterns ILD of the stack structure ST may have their thicknesses that can be changed depending on properties of a semiconductor memory device. Each of the dielectric patterns ILD may include a first dielectric pattern ILD1 positioned on the cell array region CAR and a second dielectric pattern ILD2 positioned on the connection region CNR. One of the first dielectric patterns ILD1 may be horizontally connected to its corresponding one of the second dielectric patterns ILD2. The first dielectric patterns ILD1 may include first sub-dielectric patterns ILDla provided on the first region R1 of the cell array region CAR and second sub-dielectric patterns ILDlb provided on the second region R2 of the cell array region CAR.

The first sub-dielectric patterns ILDla may include the same or similar material as that of the second dielectric patterns ILD2. Therefore, no interface may be present between the first sub-dielectric patterns ILDla and the second dielectric patterns ILD2.

As shown in FIG. 11, the second sub-dielectric patterns ILD1b may have a different material from that of the second dielectric patterns ILD2. Therefore, interfaces IF1 may be present between the second sub-dielectric patterns ILDlb and the second dielectric patterns ILD2. The interfaces IF1 between the second sub-dielectric patterns ILD1b and the second dielectric patterns ILD2 may be perpendicular to a top surface of the first substrate 1. There may be flat interfaces IF1 between the second sub-dielectric patterns ILD1b and the second dielectric patterns ILD2. Alternatively, as shown in FIG. 12, interfaces IF2 between the second sub-dielectric patterns ILDlb and the second dielectric patterns ILD2 may be bent in the first direction D1 or in a direction toward the connection region CNR from the cell array region CAR. For example, the interfaces IF2 between the second sub-dielectric patterns ILDlb and the second dielectric patterns ILD2 may be convex in the first direction D1.

As shown in FIG. 13, the second sub-dielectric patterns ILDlb and the second dielectric patterns ILD2 may have their interfaces that are aligned in the third direction D3 or in a vertical direction with respect to the top surface of the first substrate 1. Alternatively, as shown in FIG. 14, the second sub-dielectric patterns ILDlb and the second dielectric patterns ILD2 may have their interfaces that become farther away in a direction opposite to the first direction D1 from the connection region CNR as the interfaces approach closer to the first substrate 1. That is, the interfaces may not be aligned vertically.

Referring still to FIGS. 9, 10A, and 10B, the first sub-dielectric patterns ILDla may be cell dielectric patterns for insulating gate electrodes of transistors provided on the first region R1 of the stack structure ST. The second sub-dielectric patterns ILDlb may be dielectric layers located between electrodes of capacitors provided on the second region R2 of the stack structure ST. The second sub-dielectric patterns ILDlb may have a second dielectric constant greater than a first dielectric constant of the first sub-dielectric patterns ILDla and the second dielectric patterns ILD2. For example, the second sub-dielectric patterns ILDlb may be high-k dielectric patterns. The first sub-dielectric patterns ILDla and the second dielectric patterns ILD2 may include SiO. The second sub-dielectric patterns ILDlb may include Al₂O₃, TiO₂, ZrO₂, or HfO₂.

On the first region R1 of the cell array region CAR, the first vertical structures VS 1 may penetrate the stack structure ST to contact the first substrate 1. The first vertical structures VS 1 may be electrically connected to the first substrate 1. In plan view, the first vertical structures VS 1 may be arranged in a straight or zigzag fashion along one direction. The first vertical structures VS 1 may be used as channels of transistors provided on the first region R1 of the stack structure ST. On the connection region CNR, dummy vertical structures (not shown) may be provided which have substantially the same or the same structure as that of the first vertical structures VS 1.

The first vertical structures VS 1 may include a semiconductor material, such as silicon (Si), germanium (Ge), or a mixture thereof. Additionally, or alternatively, the first vertical structures VS 1 may include a semiconductor doped with impurities or an intrinsic semiconductor doped with no impurities. The first vertical structures VS 1 including the semiconductor material may be used as channels of the selection transistors SST and GST and the memory cell transistors MCT discussed above with reference to FIG. 6. The first vertical structures VS 1 may have their bottom surfaces positioned between top and bottom surfaces of the first substrate 1. The first vertical structures VS 1 may each be provided on its top end with a contact pad coupled to a bit-line contact plug BPLG which will be discussed below.

Each of the first vertical structures VS 1 may include a semiconductor pattern SP and a vertical dielectric pattern VP that are in contact with the first substrate 1. The semiconductor pattern SP may have a hollow pipe shape or a macaroni shape. A bottom end of the semiconductor pattern SP may have a closed shape, and an inside of the semiconductor pattern SP may be filled with a buried dielectric pattern VI. The semiconductor pattern SP may be in contact with the top surface of the first substrate 1. The semiconductor pattern SP may be in an undoped state or may be doped with impurities whose conductivity type is the same or similar as that of the first substrate 1. The semiconductor pattern SP may be polycrystalline or single-crystalline.

The vertical dielectric pattern VP may be disposed between the stack structure ST and the first vertical structure VS 1. The vertical dielectric pattern VP may surround a sidewall of the first vertical structure VS 1, while extending in a third direction D3. For example, the vertical dielectric pattern VP may have a macaroni shape or a pipe shape whose top and bottom ends are opened.

The vertical dielectric pattern VP may be formed of a single thin layer or a plurality of thin layers. The vertical dielectric pattern VP may be a portion of a data storage layer. For example, the vertical dielectric pattern VP may include a tunnel dielectric layer, a charge storage layer, and a blocking dielectric layer, which layers constitute a data storage layer of a NAND Flash memory device. For example, the charge storage layer may be a trap dielectric layer, a floating gate electrode, or a dielectric layer including conductive nano-dots. For more detail, the charge storage layer may include at least one selected from SiN, SiON, Si-rich nitride, nano-crystal Si, and laminated trap layers. The tunnel dielectric layer may include one of materials having a band gap greater than that of the charge storage layer, and the blocking dielectric layer may be a high-k dielectric material, such as Al₂O₃ and HfO₂. Alternatively, the vertical dielectric pattern VP may include a thin layer either for a phase change memory device or for a variable resistance memory device.

Although not shown, a horizontal dielectric pattern may be provided between the vertical dielectric pattern VP and sidewalls of the electrode patterns EL. The horizontal dielectric patterns may extend onto top and bottom surfaces of the electrode patterns EL from the sidewalls of the electrode patterns EL. The horizontal dielectric pattern may include a charge storage layer and a blocking dielectric layer that are portions of a data storage layer of an NAND Flash memory device. Alternatively, the horizontal dielectric pattern may include a blocking dielectric layer.

FIGS. 10A and 10B depicts that the stack structure ST has one stepwise structure on the connection region CNR, but the present inventive concept is not limited thereto. According to some example embodiments, the stack structure ST may include a first stack structure having a first stepwise structure and a second stack structure having a second stepwise structure on the first stack structure. The first stepwise structure and the second stepwise structure may be positioned on different sections on the connection region CNR. The first stepwise structure and the second stepwise structure may be horizontally spaced apart from each other. The first vertical structures VS1 may include first sub-vertical structures that vertically penetrate the first stack structure, and may also include second sub-vertical structures that vertically penetrate the second stack structure and are coupled to the first sub-vertical structures. On interfaces between the first sub-vertical structures and the second sub-vertical structures, widths of the second sub-vertical structures may be less than those of the first sub-vertical structures.

Alternatively, the stack structure ST may include a first stack structure having a first stepwise structure, a second stack structure having a second stepwise structure, and a third stack structure having a third stepwise structure, which first, second, and third stack structures are sequentially stacked. The first, second, and third stepwise structures may be positioned on different sections on the connection region CNR. The first, second, and third stepwise structures may be horizontally spaced apart from each other. The first vertical structures VS1 may include first sub-vertical structures that vertically penetrate the first stack structure, second sub-vertical structures that vertically penetrate the second stack structure and are coupled to the first sub-vertical structures, and third sub-vertical structures that vertically penetrate the third stack structure and are coupled to the second sub-vertical structures. On interfaces between the first sub-vertical structures and the second sub-vertical structures, widths of the second sub-vertical structures may be less than those of the first sub-vertical structures. On interfaces between the second sub-vertical structures and the third sub-vertical structures, widths of the third sub-vertical structures may be less than those of the second sub-vertical structures. The following description will relate to the example embodiments of FIGS. 10A and 10B.

On the cell array region CAR, common source regions CSR may be disposed in the first substrate 1 between neighboring stack structures ST. The common source regions CSR may extend parallel to the stack structure ST in the first direction D1. The common source regions CSR may be formed by doping the first substrate 1 with impurities having a second conductivity type. The common source regions CSR may include, for example, n-type impurities (e.g., arsenic (As) or phosphorus (P)).

On the cell array region CAR, common source plugs CSP may be provided to vertically penetrate the stack structure ST to be coupled to the common source region CSR. A side dielectric spacer SSP may be interposed between the common source plug CSP and the stack structure ST. In a read or program mode of a three-dimensional NAND Flash memory device, a ground voltage may be applied through the common source plug CSP to the common source region CSR.

The cell array region CAR may be provided with second vertical structures VS2 on the second region R2. The second vertical structure VS2 may vertically penetrate the stack structure ST to contact the first substrate 1. On the second region R2, the electrode patterns EL and the first dielectric patterns ILD1 may be in contact with lateral surfaces of the second vertical structures VS2. For example, on the second region R2, the second sub-dielectric patterns ILDlb may be in contact with the lateral surfaces of the second vertical structures VS2. According to some example embodiments, as shown in FIG. 13, the electrode patterns EL may not be in contact with the second vertical structures VS2. For example, on the second region R2, the second sub-dielectric patterns ILDlb may extend between the electrode patterns EL and the second vertical structures VS2. In other words, portions of the second sub-dielectric patterns ILDlb may cover lateral surfaces (or outside surfaces) of the second vertical structures VS2, and the electrode patterns EL may extend between the second sub-dielectric patterns ILDlb to contact the portions of the second sub-dielectric patterns ILD1b. The following description will relate to the example embodiments of FIG. 10B. The second vertical structures VS2 may include a dielectric material.

A first buried dielectric layer 150 may be disposed on the first substrate 1, while covering stepwise shaped ends of the electrode patterns EL. A top surface of the first buried dielectric layer 150 may be coplanar with that of the stack structure ST. For example, the first buried dielectric layer 150 may be a planarized dielectric layer with respect to the stack structure ST. The first buried dielectric layer 150 may include a dielectric material having an etch selectivity with respect to the dielectric patterns ILD. For example, the first buried dielectric layer 150 may include SiN.

A first interlayer dielectric layer 151 may cover the stack structure ST and the first buried dielectric layer 150. The first interlayer dielectric layer 151 may cover the first vertical structures VS1. On the first buried dielectric layer 150, the first interlayer dielectric layer 151 may surround the common source plug CSP and the second vertical structures VS2. For example, the common source plug CSP and the second vertical structures VS2 may be exposed on a top surface of the first interlayer dielectric layer 151.

The first interlayer dielectric layer 151 may be covered with second interlayer dielectric layers 153. The second interlayer dielectric layers 153 may be stacked on the first interlayer dielectric layer 151. On the first interlayer dielectric layer 151, the second interlayer dielectric layers 153 may cover the common source plug CSP and the second vertical structures VS2.

On the cell array region CAR, bit lines BL may be provided on the second interlayer dielectric layer 153 and may extend in the second direction D2 while crossing over the stack structures ST. Each of the bit lines BL may be electrically connected through a bit-line contact plug BPLG to the first vertical structure VS 1.

On the connection region CNR, stepwise shaped ends of the stack structures ST may be provided thereon with a connection structure that electrically connects the cell array structure CS to a peripheral circuit structure (not shown). The connection structure may include cell contact plugs CPLG that penetrate the first and second interlayer dielectric layers 151 and 153 and the first buried dielectric layer 150 to come into connection with corresponding ends of the electrode patterns EL, and may also include connection lines CL that are provided on the second interlayer dielectric layer 153 to come into connection with corresponding cell contact plugs CPLG. In addition, the connection structure may include well contact plugs WPLG coupled to well pick-up regions PUR in the first substrate 1, and may also include peripheral connection lines PCL connected to the well contact plugs WPLG.

The cell contact plugs CPLG may be provided on the connection region CNR. The cell contact plugs CPLG may vertically penetrate the first interlayer dielectric layer 151 and the first buried dielectric layer 150 to come into connection with the stack structure ST. For example, the cell contact plugs CPLG may be coupled to the stepwise shaped ends of the electrode patterns EL on the connection region CNR. The cell contact plugs CPLG may completely penetrate the second interlayer dielectric layers 153 to be exposed on top surfaces of the second interlayer dielectric layers 153 or may penetrate only a portion of the second interlayer dielectric layers 153. The cell contact plugs CPLG may include a conductive material.

The connection lines CL may be provided on the connection region CNR. The connection lines CL may be disposed on or between the second interlayer dielectric layers 153. The connection lines CL may be connected to the cell contact plugs CPLG. For example, one of the connection lines CL may be connected to two of the cell contact plugs CPLG. A capacitor may be constituted by a pair of electrode patterns EL that are positioned on the connection lines CL and the second region R2 and are connected to each other through the cell contact plugs CPLG and by the second sub-dielectric patterns ILD1b between the pair of electrode patterns EL.

According to some example embodiments of the present inventive concept, among the first dielectric patterns ILD1 on the cell array region CAR, the second sub-dielectric patterns ILD1b on the second region R2 where no memory cells are provided may be used to provide a capacitor. Therefore, no separate zone for providing the capacitor may be desirable or needed, and a semiconductor device may decrease in size.

In addition, the first sub-dielectric patterns ILDla whose dielectric constant is low may be provided between the electrode patterns EL that are gate electrodes of memory cells on the first region R1 of the cell array region CAR. Therefore, parasitic capacitance or tunneling may occur less frequently between the gate electrodes. In addition, the second sub-dielectric patterns ILD1b, having a high dielectric constant, may be provided between electrode patterns EL of the electrode patterns EL that are gate electrodes of memory cells on the second region R2 of the cell array region CAR. It may thus be possible to provide capacitors whose capacitance is high. As a result, a semiconductor device may have improved in electrical properties.

On the connection region CNR, the first substrate 1 may be provided therein with the well pick-up regions PUR disposed adjacent to opposite ends of each of the stack structures ST. The well pick-up regions PUR may have the same or similar conductivity type as that of the first substrate 1, and may have an impurity concentration greater than that of the first substrate 1. For example, the well pick-up regions PUR may include heavily doped p-type impurities (e.g., boron (B)). According to some example embodiments, in an erase operation of a three-dimensional NAND Flash memory device, an erase voltage may be applied through the well contact plugs WPLG to the well pick-up regions PUR.

The second interlayer dielectric layers 153 may be provided thereon with a third interlayer dielectric layer 155 that surrounds the bit lines BL, the connection lines CL, and the peripheral connection lines PCL. The third interlayer dielectric layer 155 may expose top surfaces of the bit lines BL and top surfaces of the peripheral connection lines PCL. The bit lines BL, the connection lines CL, and the peripheral connection lines PCL may constitute a cell array wiring layer 160.

In the example embodiments that follow, a detailed description of technical features repetitive to those discussed above with reference to FIGS. 1 to 13 will be omitted, and a difference thereof will be discussed in detail.

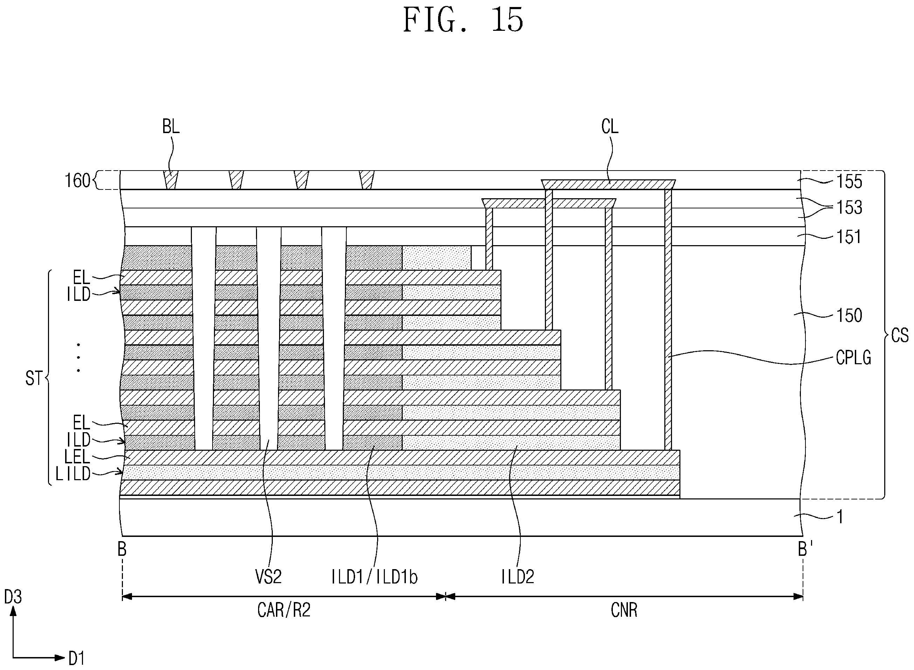

FIG. 15 illustrates a cross-sectional view taken along line B-B' of FIG. 9, showing a semiconductor device according to some example embodiments of the present inventive concept.

Referring to FIG. 15, the stack structure ST may include the electrode patterns EL that are vertically stacked on the first substrate 1 and the dielectric patterns ILD interposed between the electrode patterns EL. In some example embodiments, a lower electrode pattern LEL may indicate a lowermost one of the electrode patterns EL, and a lower dielectric pattern LILD may indicate a lowermost one of the first dielectric patterns ILD1. According to some example embodiments, the lower electrode pattern LEL and the lower dielectric pattern LILD may each be provided in plural. In this case, the lower electrode patterns LEL may be electrode patterns EL located at a bottom end or a lower end of the stack structure ST, and the lower dielectric patterns LILD may be dielectric patterns ILD located at a bottom end or a lower end of the stack structure ST. In some example embodiments, the vertical pattern VS2a may not contact the substrate 1.

The lower dielectric pattern LILD may be horizontally connected to a lowermost second dielectric pattern ILD2. The lower dielectric pattern LILD may include the same or similar material as that of the first sub-dielectric patterns ILD1a and that of the second dielectric patterns ILD2. Therefore, no interface may be present between the lower dielectric pattern LILD and the second dielectric patterns ILD2. The lower dielectric pattern LILD may be formed of one material on the first region R1 and the second region R2. For example, on the second region R2, the lower dielectric pattern LILD whose dielectric constant is low may be positioned below the second sub-dielectric patterns ILDlb whose dielectric constant is high. On the first region R1, the lower dielectric pattern LILD may be positioned below the first sub-dielectric patterns ILDla whose dielectric constant is the same or similar as that of the lower dielectric pattern LILD. The lower dielectric pattern LILD may include SiO.

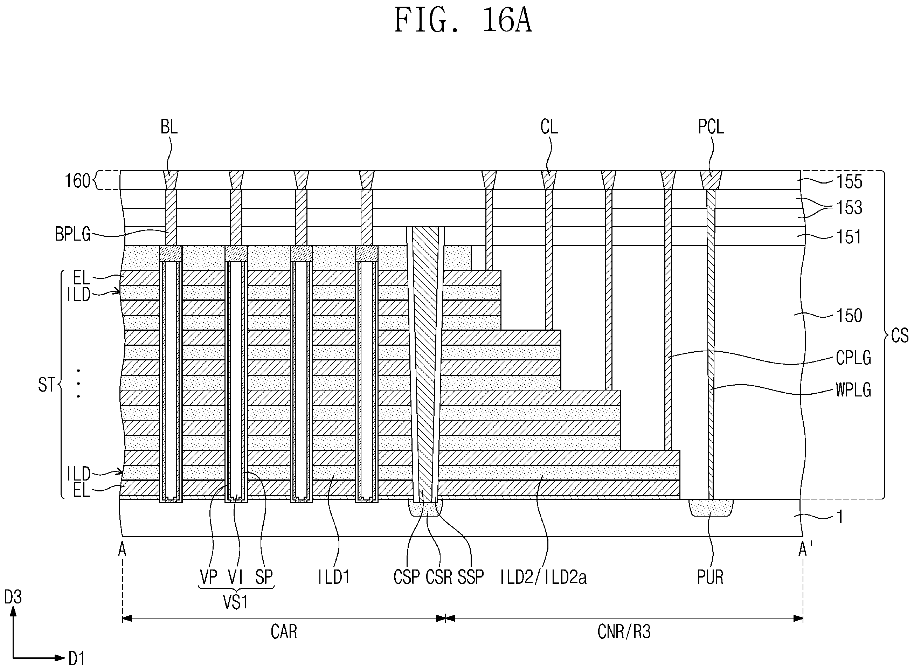

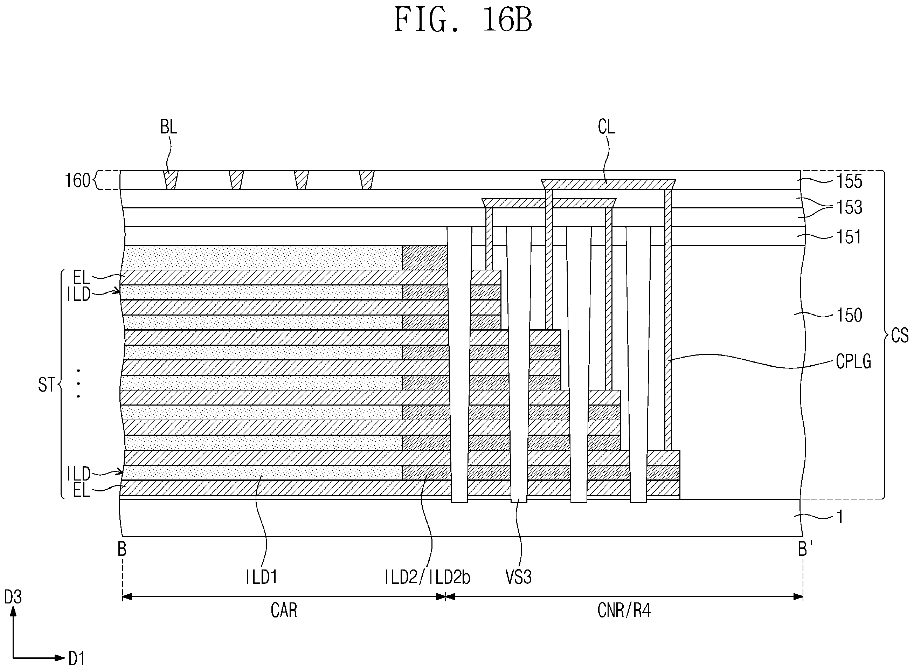

FIGS. 16A and 16B illustrate cross-sectional views respectively taken along lines A-A' and B-B' of FIG. 9, showing a semiconductor device according to embodiments of the present inventive concept.

Referring to FIGS. 16A and 16B, the first substrate 1 may include the cell array region CAR and the connection region CNR around the cell array region CAR. The connection region CNR may have a third region R3 and a fourth region R4 that are distinguished from each other.

The stack structure ST may include the electrode patterns EL that are vertically stacked on the first substrate 1 and the dielectric patterns ILD interposed between the electrode patterns EL. Each of the dielectric patterns ILD may include the first dielectric pattern ILD1 positioned on the cell array region CAR and the second dielectric pattern ILD2 positioned on the connection region CNR. One of the first dielectric patterns ILD1 may be horizontally connected to its corresponding one of the second dielectric patterns ILD2. The second dielectric patterns ILD2 may include third sub-dielectric patterns ILD2a provided on the third region R3 of the connection region CNR and fourth sub-dielectric patterns ILD2b provided on the fourth region R4 of the connection region CNR.

The third sub-dielectric patterns ILD2a may include the same or similar material as that of the first sub-dielectric patterns ILD1. Therefore, no interface may be present between the third sub-dielectric patterns ILD2a and the first dielectric patterns ILD1.

The fourth sub-dielectric patterns ILD2b may include a different material from that of the first dielectric patterns ILD1. Therefore, interfaces may be present between the fourth sub-dielectric patterns ILD2b and the first dielectric patterns ILD1. The third sub-dielectric patterns ILD2a may be cell dielectric patterns provided between gate electrodes of memory cells. The fourth sub-dielectric patterns ILD2b may be dielectric layers provided between electrodes of capacitors. In some example embodiments, the interfaces may be flat or curved as described above.

The fourth sub-dielectric patterns ILD2b may have a dielectric constant greater than that of the third sub-dielectric patterns ILD2a and that of the first dielectric patterns ILD1. For example, the fourth sub-dielectric patterns ILD2b may be high-k dielectric patterns. The third sub-dielectric patterns ILD2a and the first dielectric patterns ILD1 may include SiO. The fourth sub-dielectric patterns ILD2b may include Al₂O₃, TiO₂, ZrO₂, or HfO₂.

The connection region CNR may be provided with third vertical structures VS3 on the fourth region R4. The third vertical structures VS3 may vertically penetrate the first interlayer dielectric layer 151, the first buried dielectric layer 150, and the stack structure ST, thereby contacting the first substrate 1. For example, the third vertical structures VS3 may penetrate ends of the electrode patterns EL and the fourth sub-dielectric patterns ILD2b that have a stepwise structure on the fourth region R4 of the connection region CNR. The third vertical structures VS3 may be in contact with the fourth sub-dielectric patterns ILD2b. The third vertical structures VS3 may be exposed on the top surface of the first interlayer dielectric layer 151. The third vertical structures VS3 may include a dielectric material.

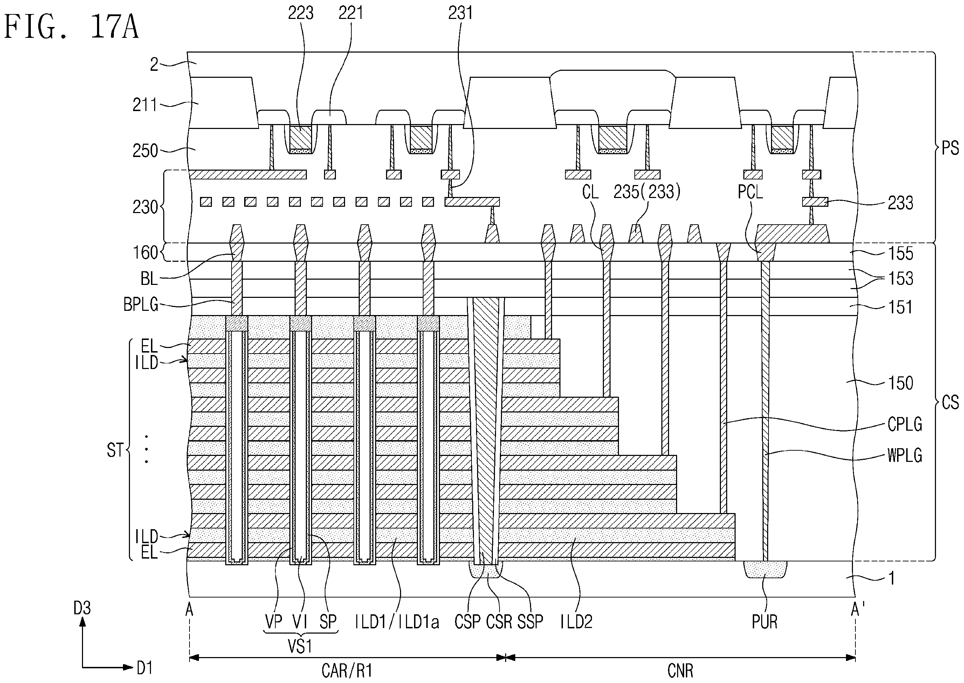

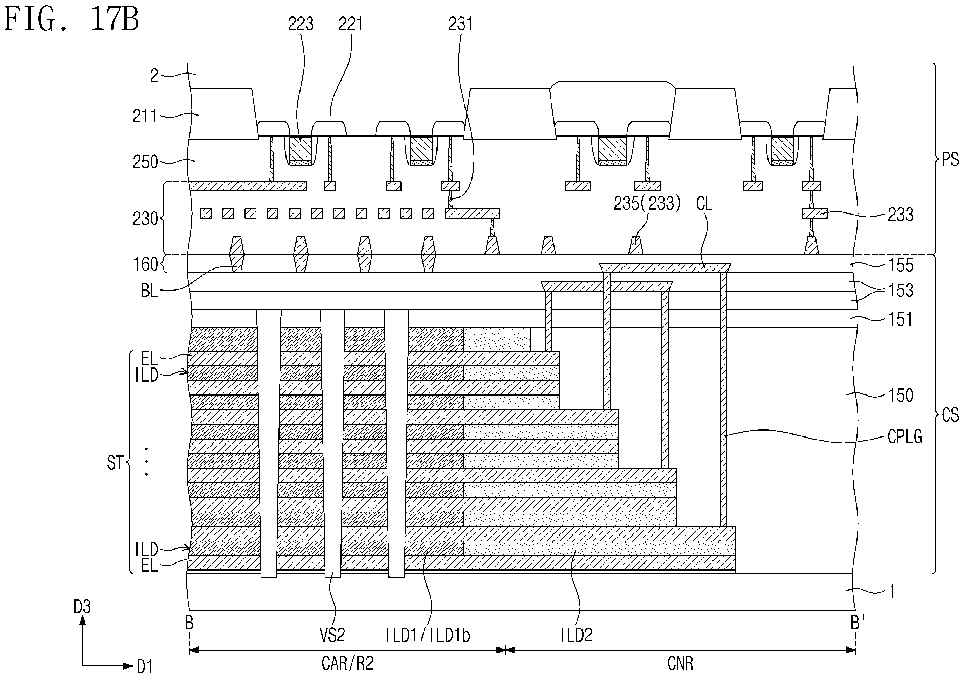

FIGS. 17A and 17B illustrate cross-sectional views respectively taken along lines A-A' and B-B' of FIG. 9, showing a semiconductor device according to embodiments of the present inventive concept.

Referring to FIGS. 17A and 17B, the cell array structure CS may be provided on the first substrate 1, and may include the stack structures ST, the vertical structures VS1 and VS2, and the connection structures CPLG, CL, WPLG, and PCL. The first substrate 1 and the cell array structure CS may be the first substrate 1 and the cell array structure CS discussed with reference to FIGS. 9 to 16A and 16B. A peripheral circuit structure PS may be disposed on the cell array structure CS.

A second substrate 2 may be provided. The second substrate 2 may be a silicon (Si) substrate, a silicon-germanium (SiGe) substrate, or a single-crystalline epitaxial layer grown on a single-crystalline silicon (Si) substrate. For example, the second substrate 2 may be a silicon substrate having a first conductivity type (e.g., p-type) and may include well regions.

The peripheral circuit structure PS may include peripheral circuits that are integrated on an entire surface of the second substrate 2 and a second buried dielectric layer 250 that covers the peripheral circuits. The peripheral circuits may be, as discussed above, row and column decoders, page buffers, and a control circuit, and may include NMOS and PMOS transistors, low-voltage and high-voltage transistors, and a resistor that are integrated on one surface of the second substrate 2. For example, the second substrate 2 may be provided therein with a device isolation layer 211 that defines active sections. The second substrate 2 may be provided on its active section with peripheral gate electrodes 223, and gate dielectric layers may be interposed between the peripheral gate electrodes 223 and the second substrate 2. The second substrate 2 may have therein with source/drain sections 221 provided on opposite sides of each of the peripheral gate electrodes 223.

A peripheral circuit wiring layer 230 may be connected to the peripheral circuits on the second substrate 2. The peripheral circuit wiring layer 230 may include peripheral circuit lines 233 and peripheral circuit contact plugs 231. The peripheral circuit lines 233 may be electrically connected through the peripheral circuit contact plugs 231 to the peripheral circuits. For example, the peripheral circuit contact plugs 231 and the peripheral circuit lines 233 may be coupled to the NMOS and PMOS transistors.

The second buried dielectric layer 250 may cover the peripheral gate electrodes 223, the peripheral circuit contact plugs 231, and the peripheral circuit lines 233. The second buried dielectric layer 250 may expose a portion of the peripheral circuit wiring layer 230, for example, portions 235 (or exposed wiring lines) of the peripheral circuit lines 233. The second buried dielectric layer 250 may include a plurality of stacked dielectric layers. For example, the second buried dielectric layer 250 may include one or more of SiO, SiN, SiON, and low-k dielectric materials.

The cell array structure CS and the peripheral circuit structure PS may be in direct contact with each other. For example, as shown in FIGS. 17A and 17B, the cell array wiring layer 160 of the cell array structure CS may be in contact with the peripheral circuit wiring layer 230 of the peripheral circuit structure PS. For example, the third interlayer dielectric layer 155 may be in contact with the second buried dielectric layer 250, and the exposed wiring lines 235 may be connected to the bit lines BL and one or more of the peripheral connection lines PCL. In this case, an intermetallic hybrid bonding may be provided between the cell array wiring layer 160 and the peripheral circuit wiring layer 230. In this description, the term "hybrid bonding" may denote a bonding in which two components of the same or similar kind are merged at an interface therebetween. For example, the exposed wiring lines 235 may have continuous configurations with the bit lines BL and the peripheral connection lines PCL, and thus no interface may be visually recognized between the exposed wiring line 235 and each of the bit lines BL and the peripheral connection lines PCL. For example, the exposed wiring lines 235 may be formed of the same or similar material as that of the bit lines BL and the peripheral connection lines PCL, and thus no interface may be present between the exposed wiring line 235 and each of the bit lines BL and the peripheral connection lines PCL. Accordingly, the exposed wiring line 235 and each of the bit line BL and the peripheral connection line PCL may be formed into a single unitary component.

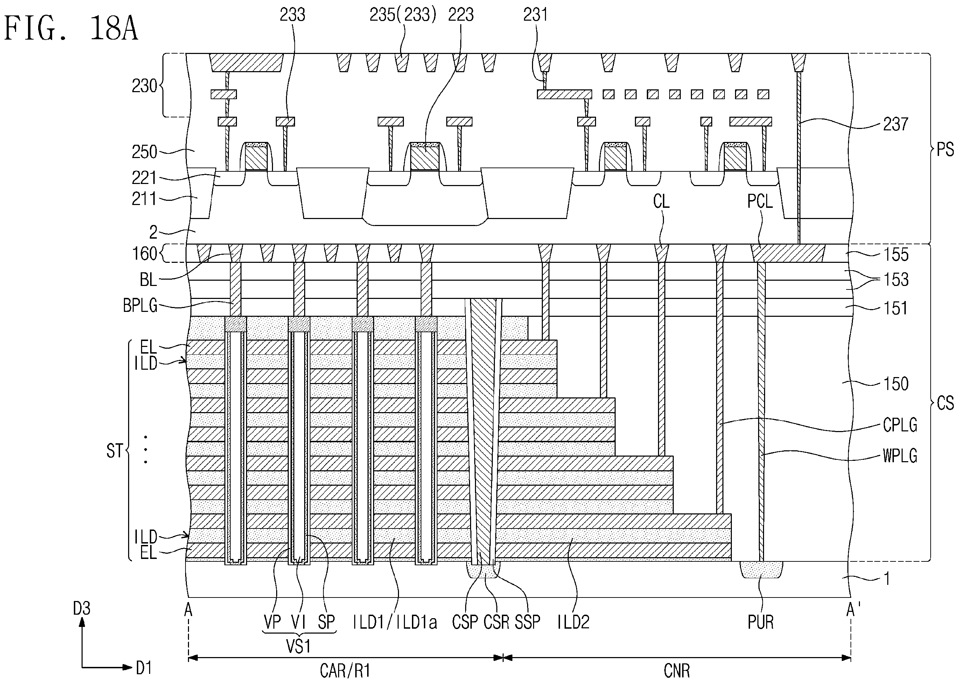

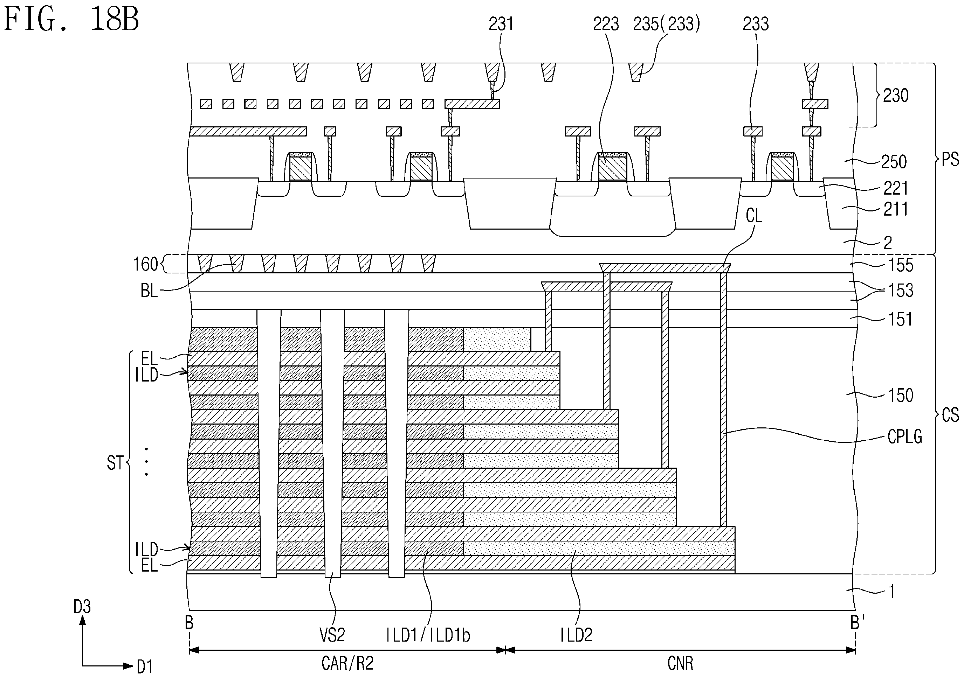

FIGS. 18A and 18B illustrate cross-sectional views respectively taken along lines A-A' and B-B' of FIG. 9, showing a semiconductor device according to embodiments of the present inventive concept.

Referring to FIGS. 18A and 18B, the peripheral circuit structure PS may be disposed on the cell array structure CS.

The cell array structure CS and the peripheral circuit structure PS may be in direct contact with each other. For example, the third interlayer dielectric layer 155 of the cell array structure CS may be in contact with the second substrate 2 of the peripheral circuit structure PS. For example, the second substrate 2 may be a polycrystalline or single-crystalline silicon (Si) layer deposited by using a deposition method on the third interlayer dielectric layer 155. To achieve an electrical connection between the cell array wiring layer 160 and the peripheral circuit wiring layer 230, the peripheral circuit wiring layer 230 may further include a peripheral circuit via 237 that penetrates the second buried dielectric layer 250 and the second substrate 2. The peripheral circuit via 237 may connect the peripheral circuit lines 233 to the peripheral connection lines PCL. Alternatively, the peripheral circuit via 237 may connect the peripheral circuit lines 233 to the bit lines BL or the connection lines CL.

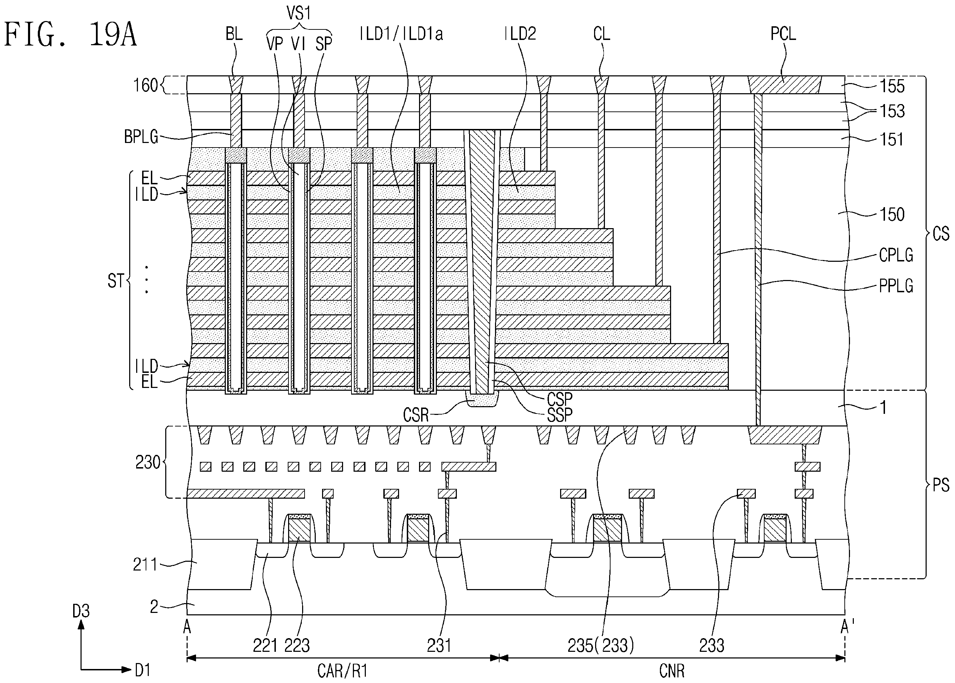

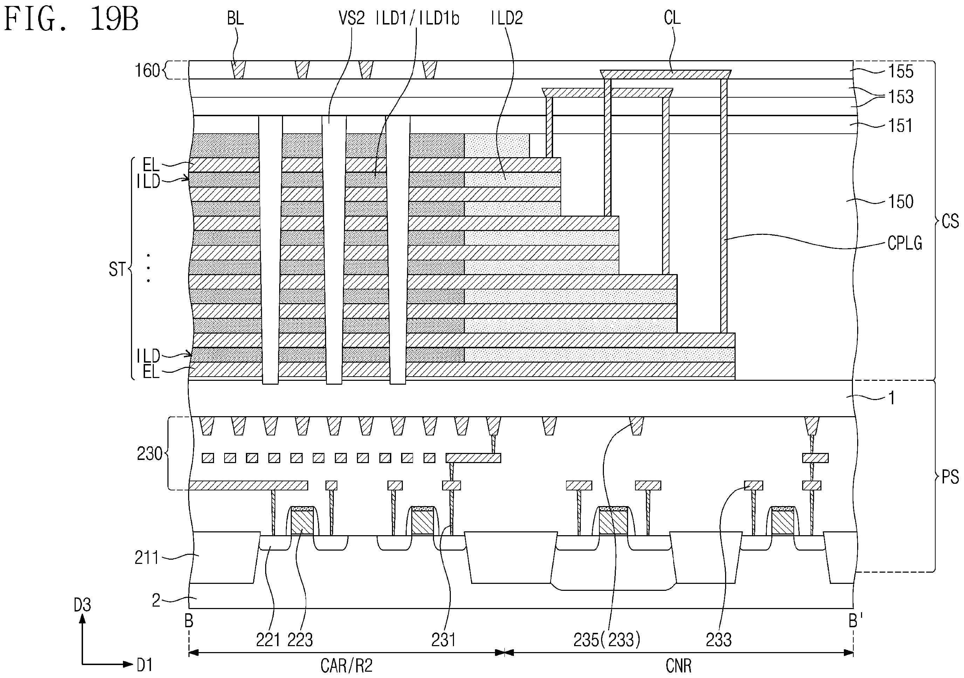

FIGS. 19A and 19B illustrate cross-sectional views respectively taken along lines A-A' and B-B' of FIG. 9, showing a semiconductor device according to embodiments of the present inventive concept.

Referring to FIG. 19, the cell array structure CS may be disposed on the peripheral circuit structure PS.

The cell array structure CS and the peripheral circuit structure PS may be in direct contact with each other. For example, the second buried dielectric layer 250 of the peripheral circuit structure PS may be in contact with the first substrate 1 of the cell array structure CS. In some example embodiments, the first substrate 1 may be a polycrystalline or single-crystalline silicon (Si) layer deposited by using a deposition method on the second buried dielectric layer 250. To achieve an electrical connection between the cell array wiring layer 160 and the peripheral circuit wiring layer 230, a connection structure of the cell array structure CS may include connection contact plugs PPLG that penetrate the buried dielectric layers 150 and 250 to be coupled to the peripheral circuit lines 233. Although not shown, the peripheral connection lines PCL may connect the connection contact plugs PPLG to the well contact plugs WPLG.

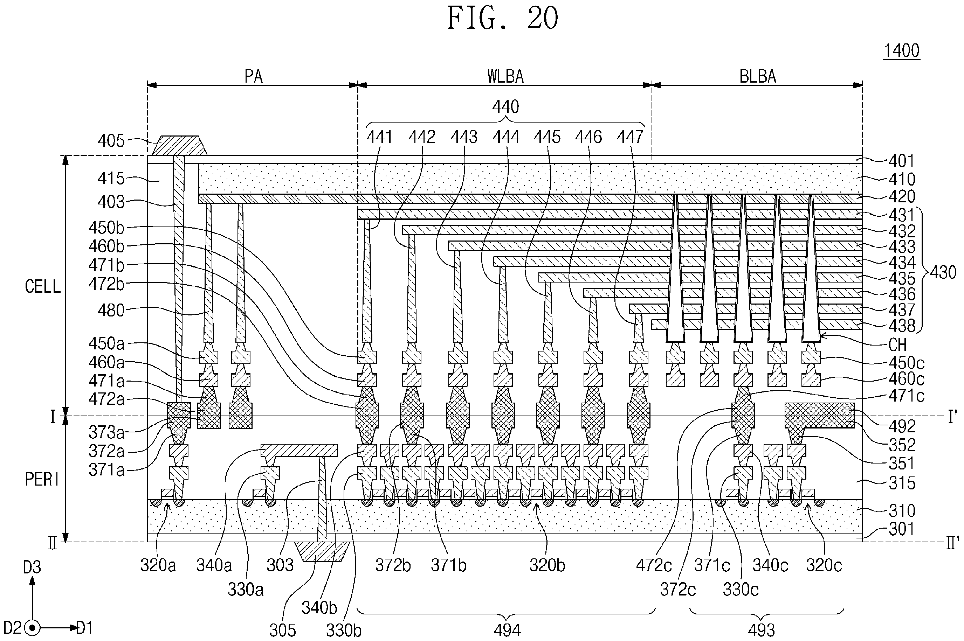

FIG. 20 illustrates a cross-sectional view showing a semiconductor device according to some example embodiments of the present inventive concept.

Referring to FIG. 20, a semiconductor device 1400 of some example embodiments may be a memory device. The memory device 1400 may have a chip-to-chip (C2C) structure. The chip-to-chip (C2C) structure may be fabricated by forming on a first wafer an upper chip including a cell region CELL, forming on a second wafer different from the first wafer a lower chip including a peripheral circuit region PERI, and then using a bonding method to connect the upper and lower chips to each other. For example, the bonding method may include electrically connecting a bonding metal formed on an uppermost metal layer of the upper chip to a bonding metal formed on an uppermost metal layer of the lower chip. For example, when the bonding metal is formed of copper (Cu), the bonding method may be a Cu-Cu bonding method, and the bonding metal may be formed of aluminum (Al) or tungsten (W).

Each of the peripheral circuit region PERI and the cell region CELL of the memory device 1400 may include an outer pad bonding area PA, a word-line bonding area WLBA, and a bit-line bonding area BLBA.

The peripheral circuit region PERI may include a first substrate 310, an interlayer dielectric layer 315, a plurality of circuit elements 320a, 320b, and 320c formed on the first substrate 310, a first metal layer 330a, 330b, and 330c connected to the plurality of circuit elements 320a, 320b, and 320c, and a second metal layer 340a, 340b, and 340c formed on the first metal layer 330a, 330b, and 330c.

The first substrate 1 may be a silicon (Si) substrate, a silicon-germanium (SiGe) substrate, or a single-crystalline epitaxial layer grown on a single-crystalline silicon (Si) substrate. For example, the first substrate 1 may be a silicon substrate having a first conductivity type (e.g., p-type) and may include well regions.

The plurality of circuit elements 320a to 320c formed on the first substrate 1 may include a free charge control circuit that controls a plurality of data program steps for a plurality of memory cells and controls one or more of a plurality of cell strings. The plurality of circuit elements 320a to 320c may have source/drain sections spaced apart from each other. The first metal layer 330a to 330c may be formed of a material whose resistance is relatively high (for example, such as tungsten or the like), and the second metal layer 340a to 340c may be formed of a material whose resistance is relatively low (for example, such as copper or the like). In this description, only the first and second metal layers 330a to 330c and 340a to 340c are illustrated and described, but the present inventive concept is not limited thereto and for example at least one metal layer may further be formed on the second metal layer 340a to 340c. At least a portion of at least one metal layer formed on the second metal layer 340a to 340c may be formed of a material whose resistance is less than that of the material of the second metal layer 340a to 340c (for example, such as aluminum compared to copper) included in the second metal layer 340a to 340c.

The interlayer dielectric layer 315 may be disposed on the first substrate 310 so as to cover the plurality of circuit elements 320a to 320c, the first metal layer 330a to 330c, and the second metal layer 340a to 340c, and may include a dielectric material, such as SiO and SiN.

A lower bonding metal 371b and 372b may be formed on the second metal layer 340b of the word-line bonding area WLBA. On the word-line bonding area WLBA, the lower bonding metal 371b and 372b of the peripheral circuit region PERI may be electrically bonded and connected to an upper bonding metal 471b and 472b of the cell region CELL, and the lower bonding metal 371b and 372b and the upper bonding metal 471b and 472b may be formed of a metallic material, such as Al, Cu, or W and alloys thereof. The upper bonding metal 471b and 472b of the cell region CELL may be called first metal pads, and the lower bonding metal 371b and 372b of the peripheral circuit region PERI may be called second metal pads.

The cell region CELL may provide at least one memory block. The cell region CELL may include a second substrate 410 and a common source line 420.

The second substrate 410 may be formed of a semiconductor material and may be, for example, a silicon (Si) substrate, a silicon-germanium (SiGe) substrate, or a single-crystalline epitaxial layer grown on a single-crystalline silicon (Si) substrate. For example, the second substrate 410 may be a silicon (Si) substrate. In addition, the second substrate 410 may include a semiconductor doped with impurities having a first conductivity type (e.g., p-type) and/or an intrinsic semiconductor doped with no impurities.

The second substrate 410 may be provided thereon with a plurality of word lines 431 to 438 (or 430) that are stacked along a direction (e.g., a third direction D3) perpendicular to a top surface of the second substrate 410. The word lines 430 may be provided with string selection lines on an upper portion thereof and a ground selection line on a lower portion thereof, and the plurality of word lines 430 may be disposed between the string selection lines and the ground selection line.

On the bit-line bonding area BLBA, a channel structure CH may extend in a direction perpendicular to the top surface of the second substrate 410, and may penetrate the word lines 430, the string selection lines, and the ground selection line. The channel structure CH may include a data storage layer, a channel layer, and a buried dielectric layer, and the channel layer may be electrically connected to a first metal layer 450c and a second metal layer 460c. For example, the first metal layer 450c may be a bit-line contact, and the second metal layer 460c may be a bit line. In some example embodiments, the bit line 460c may extend along a second direction D2 parallel to the top surface of the second substrate 410.

The bit-line bonding area BLBA may be defined to indicate a zone on which are disposed the channel structure CH and the bit line 460c. On the bit-line bonding area BLBA, the bit lines 460c may be electrically connected to the circuit elements 320c that provide a page buffer 493 on the peripheral circuit region PERI. For example, the bit line 460c may be connected to an upper bonding metal 471c and 472c on the peripheral circuit region PERI, and the upper bonding metal 471c and 472c may be connected to a lower bonding metal 371c and 372c connected to the circuit elements 320c of the page buffer 493.

On the word-line bonding area WLBA, the word lines 430 may extend along a first direction D1 parallel to the top surface of the second substrate 410, and may be connected to a plurality of cell contact lugs 441 to 447 (or 440). The word lines 430 and the cell contact plugs 440 may be connected to each other at pads that are at least portions of the word lines 430, which at least portions extend different lengths along the second direction D2. A first metal layer 450b and a second metal layer 460b may be sequentially connected to upper portions of the cell contact plugs 440 connected to the word lines 430. On the word-line bonding area WLBA, the cell contact plugs 440 may be connected to the peripheral circuit region PERI through the upper bonding metal 471b and 472b of the cell region CELL and through the lower bonding metal 371b and 372b of the peripheral circuit region PERI. On the bit-line bonding area BLBA, a capacitor may be constituted by at least a pair of word lines 430 that are connected to each other. On a portion of the bit-line bonding area BLBA, a high-k dielectric material may fill between the pair of word lines 430. This may be identical or similar to that discussed with reference to FIGS. 9 to 19A and 19B.

The cell contact plugs 440 may be electrically connected to the circuit elements 320b that provide a row decoder 494 on the peripheral circuit region PERI. An operating voltage of the circuit elements 320b that provide the row decoder 494 may be different from that of the circuit elements 320c that provide the page buffer 493. For example, the operating voltage of the circuit elements 320c that provide the page buffer 493 may be greater than that of the circuit elements 320b that provide the row decoder 494. In response to a control of the circuit elements 320a, 320b, and 320c of the first substrate 310, the row decoder 494 may activate at least a portion of the word lines 430.

A common source line contact plug 480 may be disposed on an outer pad bonding area PA. The common source line contact plug 480 may be formed of a conductive material, such as metal, metal compound, or polysilicon, and may be electrically connected to the common source line 420. A first metal layer 450a and a second metal layer 460a may be sequentially stacked on an upper portion of the common source line contact plug 480. For example, the outer pad bonding area PA may be defined to indicate a zone on which are disposed the common source line contact plug 480, the first metal layer 450a, and the second metal layer 460a.

Input/output pads 305 and 405 may be disposed on the outer pad bonding area PA. A lower dielectric layer 301 may be formed below the first substrate 310 to cover a bottom surface of the first substrate 310, and a first input/out pad 305 may be formed on the lower dielectric layer 301. The first input/output pad 305 may be connected through a first input/output contact plug 303 to at least one of the plurality of circuit elements 320a, 320b, and 320c disposed on the peripheral circuit region PERI, and the lower dielectric layer 301 may separate the first input/output pad 305 from the first substrate 310. In addition, a side dielectric layer may be disposed between the first input/output contact plug 303 and the first substrate 310, and may electrically separate the first input/output contact plug 303 from the first substrate 310.

An upper dielectric layer 401 may be formed on the second substrate 410 to cover a top surface of the second substrate 410, and a second input/output pad 405 may be disposed on the upper dielectric layer 401. The second input/output pad 405 may be connected through a second input/output contact plug 403 to at least one of the plurality of circuit elements 320a, 320b, and 320c disposed on the peripheral circuit region PERI.

Neither the second substrate 410 nor the common source line 420 may be disposed on a zone on which the second input/output contact plug 403 is disposed. In addition, the second input/output pad 405 may not overlap in the third direction D3 with the word lines 430. The second input/output contact plug 403 may be separated from the second substrate 410 in a direction parallel to the top surface of the second substrate 410, and may penetrate an interlayer dielectric layer 415 of the cell region CELL to come into connection with the second input/output pad 405.

The first input/output pad 305 and the second input/output pad 405 may be selectively formed. For example, the memory device 1400 may include only either the first input/output pad 305 disposed on the first substrate 310 or the second input/output pad 405 disposed on the second substrate 410. For another example, the memory device 1400 may include all of the first input/output pad 305 and the second input/output pad 405.

On each of the outer pad bonding area PA and the bit-line bonding area BLBA that are included in each of the cell region CELL and the peripheral circuit region PERI, a metal pattern at an uppermost metal layer may be present as a dummy pattern, or the uppermost metal layer may be absent.

The memory device 1400 may be configured such that, on the outer pad bonding area PA, a lower metal pattern 373a may be formed at an uppermost metal layer of the peripheral circuit region PERI to correspond to an upper metal pattern 472a formed at an uppermost metal layer of the cell region CELL, and that the lower metal pattern 373a may have the same or similar shape as that of the upper metal pattern 472a. The lower metal pattern 373a formed at the uppermost metal layer of the peripheral circuit area PERI may not be connected to a separate contact on the peripheral circuit area PERI. Similarly, on the outer pad bonding area PA, an upper metal pattern may be formed at an upper metal layer of the cell region CELL to correspond to a lower metal pattern at an uppermost metal layer of the peripheral circuit region PERI, and the upper metal pattern may have the same or similar shape as that of the lower metal pattern.

A lower bonding metal 371b and 372b may be formed on the second metal layer 340b of the word-line bonding area WLBA. On the word-line bonding area WLBA, the lower bonding metal 371b and 372b of the peripheral circuit region PERI may be electrically connected to the upper bonding metal 471b and 472b of the cell region CELL.

Moreover, on the bit-line bonding area BLBA, an upper metal pattern 492 may be formed at an uppermost metal layer of the cell region CELL to correspond to a lower metal pattern 252 formed at an uppermost metal layer of the peripheral region PERI, and the upper metal pattern 492 may have the same or similar shape as that of the lower metal pattern 252. No contact may be formed on the upper metal pattern 492 formed at an uppermost metal layer of the cell region CELL.

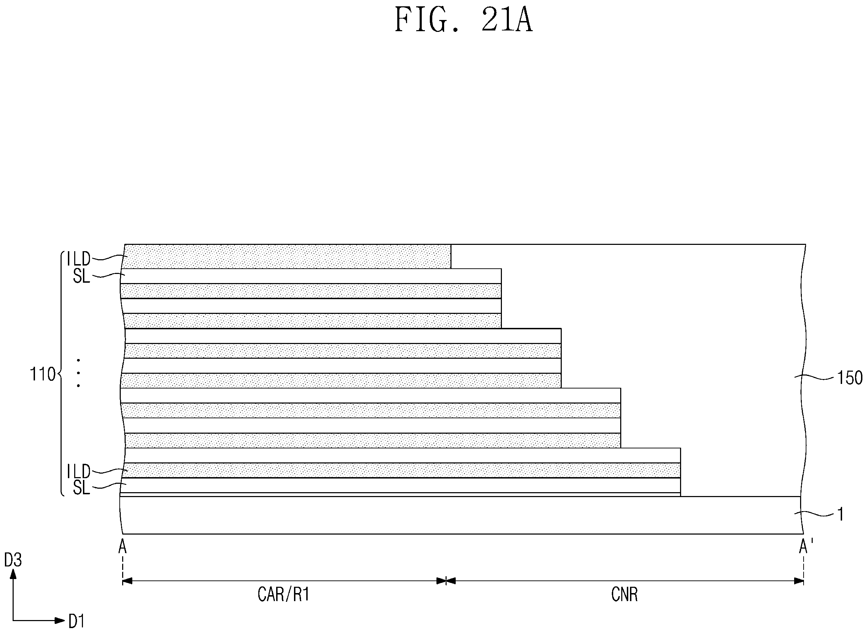

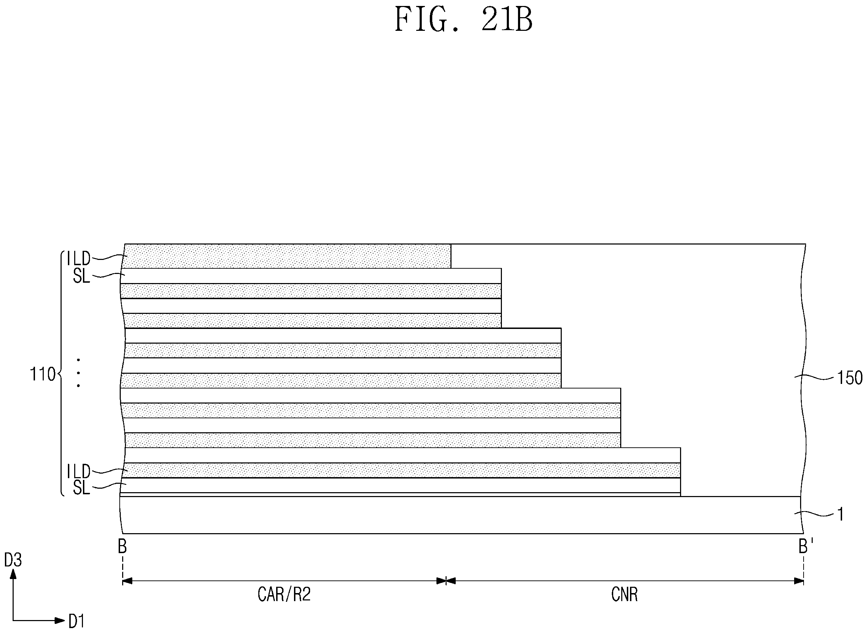

FIGS. 21A to 29A and 21B to 29B illustrate cross-sectional views respectively taken along lines A-A' and B-B' of FIG. 9, showing a method of fabricating a semiconductor device according to embodiments of the present inventive concept.

Referring to FIGS. 9, 21A, and 21B, a first substrate 1 may be prepared. The first substrate 1 may include a cell array region CAR and a connection region CNR around the cell array region CAR. The cell array region CAR may have a first region R1 and a second region R2 that are distinguished from each other.

A thin-layer structure may be formed on the first substrate 1. The thin-layer structure may include sacrificial layers SL and dielectric patterns ILD that are alternately and repeatedly stacked. The sacrificial layers SL may be formed of a material that can be etched with an etch selectivity with respect to the dielectric patterns ILD. Afterwards, the thin-layer structure may undergo a patterning process to form a mold structure 110 on the first substrate 1. The mold structure 110 may be formed by performing a trimming process on the thin-layer structure. The trimming process may include forming a mask pattern on the thin-layer structure, and repeatedly performing a process to etch a portion of the thin-layer structure positioned on the connection region CNR and a process to reduce a horizontal area of the mask pattern. The trimming process may result in allowing the mold structure 110 to have a stepwise structure on the connection region CNR of the first substrate 1.

A first buried dielectric layer 150 may be formed on the first substrate 1 on which the mold structure 110 is formed. The first buried dielectric layer 150 may be formed by deposing a thick dielectric layer to cover the mold structure 110 and then performing a planarization process on the dielectric layer.

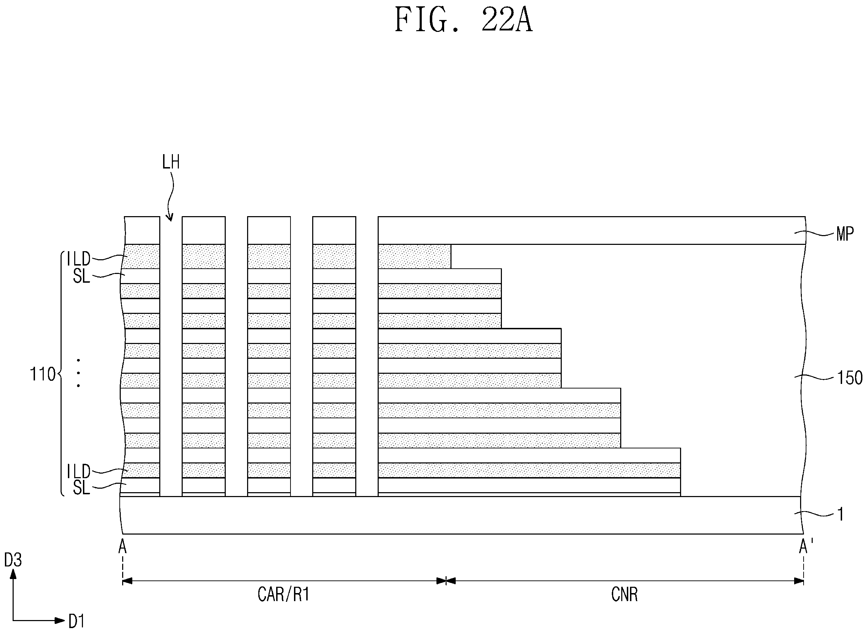

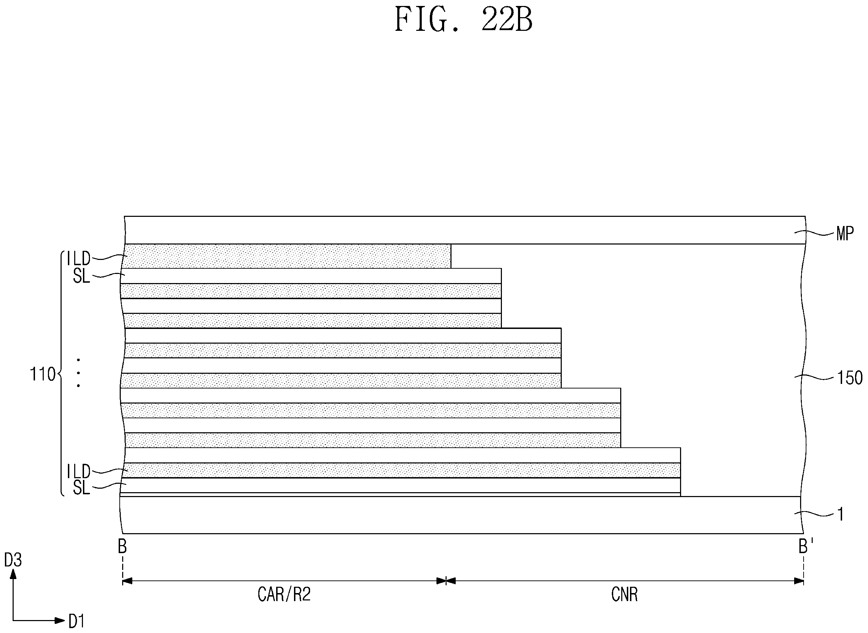

Referring to FIGS. 9, 22A, and 22B, on the first region R1 of the cell array region CAR, a hardmask layer MP may be formed to have openings that expose portions of the mold structure 110. The hardmask layer MP may be used as an etching mask such that the mold structure 110 may be anisotropically etched to form vertical holes LH that expose the first substrate 1.

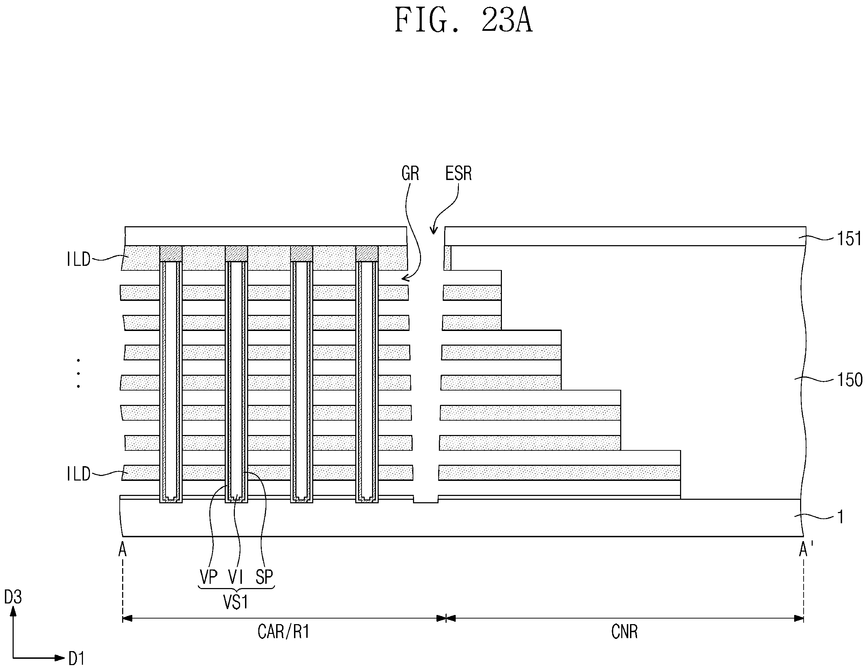

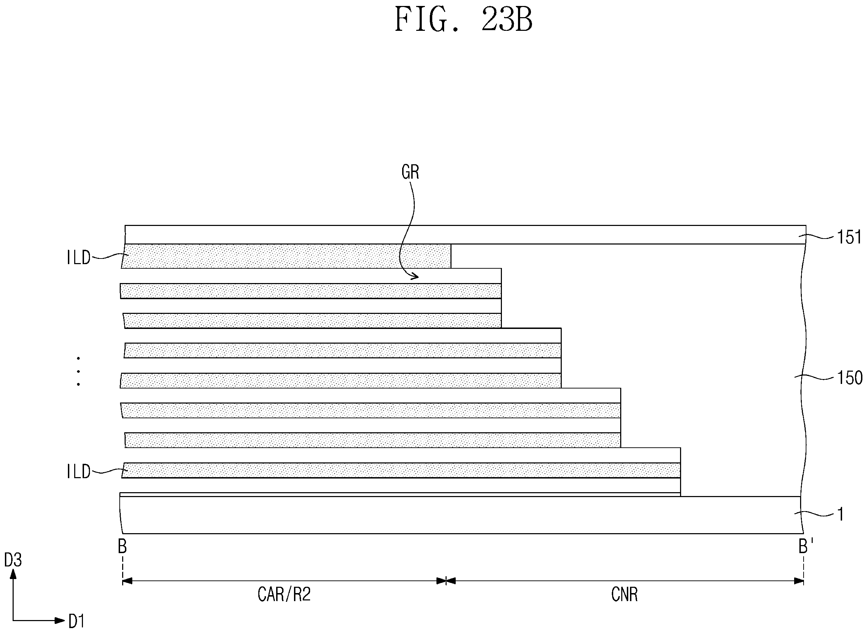

Referring to FIGS. 9, 23A, and 23B, on the first region R1 of the cell array region CAR, first vertical structures VS1 may be formed in the vertical holes LH. The first vertical structures VS1 may include a semiconductor material or a conductive material. The formation of the first vertical structures VS1 may include forming a semiconductor spacer that exposes the first substrate 1 and covers sidewalls of the openings, and then forming a semiconductor body connected to the first substrate 1. The first vertical structures VS1 may be connected to the first substrate 1.

A first interlayer dielectric layer 151 may be formed on the first buried dielectric layer 150, covering top surfaces of the first vertical structures VS1. After the formation of the first interlayer dielectric layer 151, electrode separation regions ESR may be formed to penetrate the mold structure 110 and to expose the first substrate 1. The electrode separation regions ESR may be formed by anisotropically etching the mold structure 110, and may expose sidewalls of the mold structure 110.

The sacrificial layers SL exposed to the electrode separation regions ESR may be removed to form gate regions GR. The sacrificial layers SL may be completely removed by an isotropic etching process. When the gate regions GR are formed, the first vertical structures VS1 may prevent or reduce collapse of the dielectric patterns ILD that define the gate regions GR. The gate regions GR may be empty spaces between the dielectric patterns ILD that are vertically adjacent to each other, and may expose portions of sidewalls of the first vertical structures VS1. The gate regions GR may also expose sidewalls of the first buried dielectric layer 150.

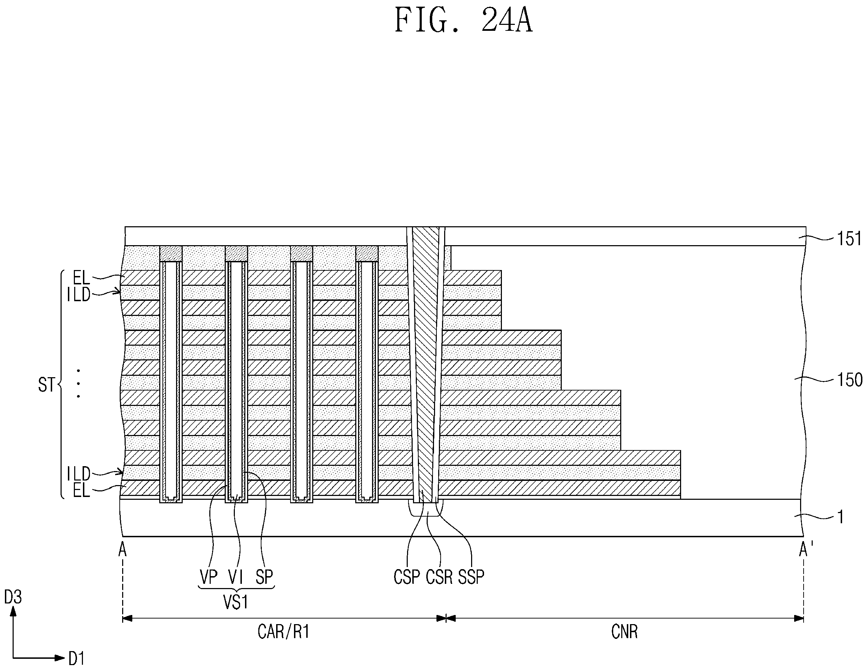

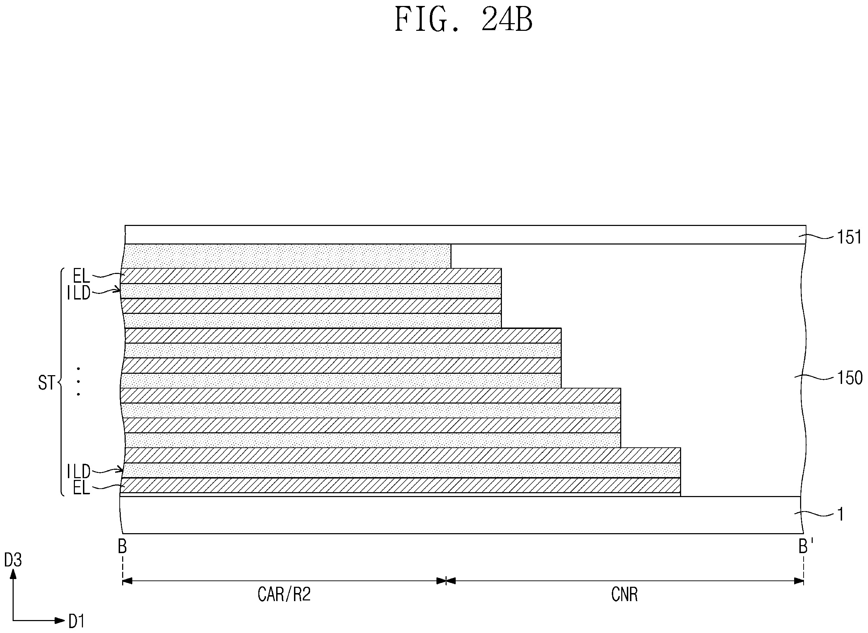

Referring to FIGS. 9, 24A, and 24B, electrode patterns EL may be formed in the gate regions GR, and thus a stack structure ST may be formed on the first substrate 1. For example, the electrode patterns EL may be formed by depositing a metal layer (e.g., W) on the mold structure 110 in which the gate regions GR are formed, and anisotropically etching the metal layer deposited on inner walls of the electrode separation regions ESR.

After the formation of the electrode patterns EL, common source regions CSR may be formed in the first substrate 1 exposed to the electrode separation regions ESR, and the electrode separation regions ESR may be filled with a dielectric material. The common source regions CSR may include, for example, n-type impurities (e.g., arsenic (As) or phosphorus (P)). A common source plug CSP may be formed in the electrode separation region ESR to come into contact with the common source region CSR with which the dielectric material is filled.

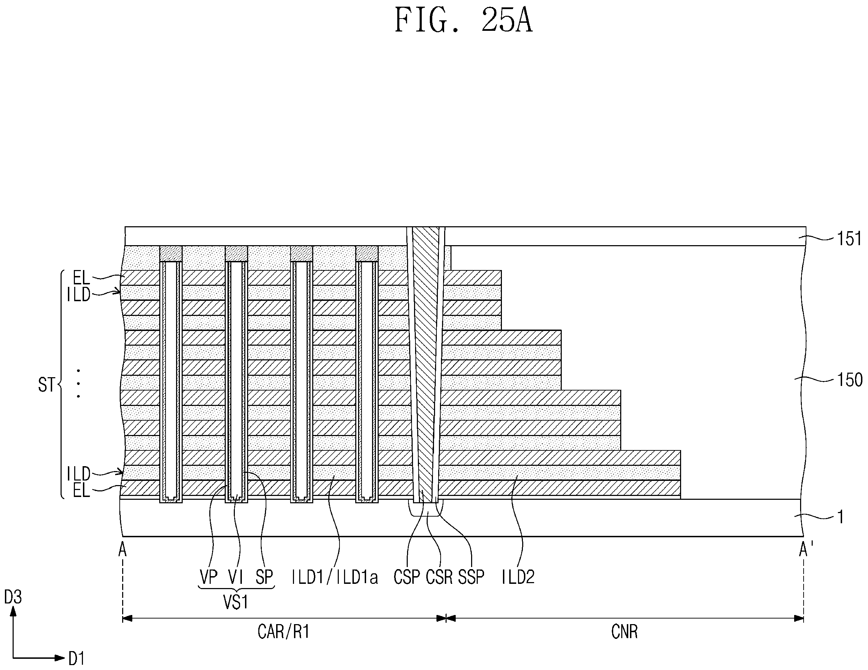

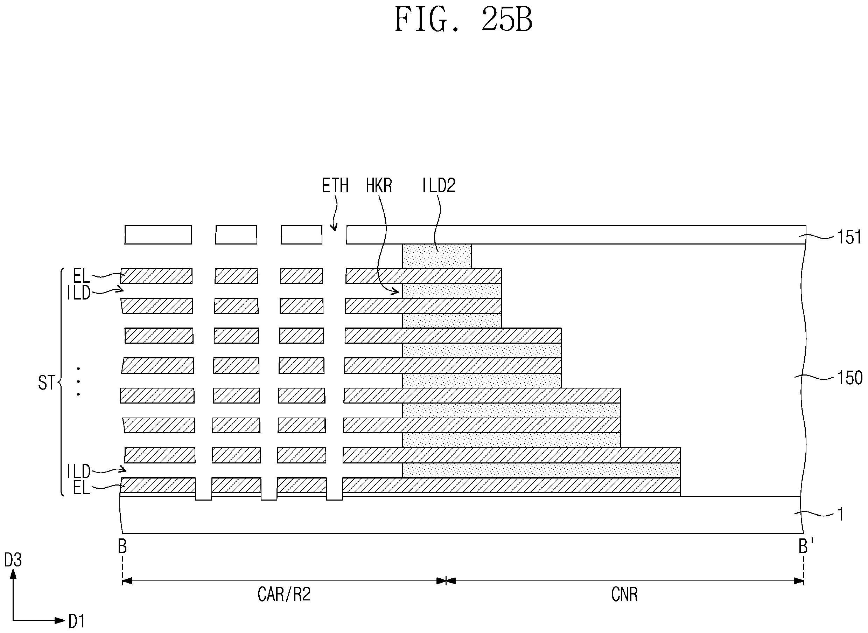

Referring to FIGS. 9, 25A, and 25B, on the second region R2 of the cell array region CAR, etching holes ETH may be formed to penetrate the stack structure ST and to expose the first substrate 1. The etching holes ETH may be formed by anisotropically etching the stack structure ST, and may expose sidewalls of the stack structure ST.

On the second region R2 of the cell array region CAR, portions of the dielectric patterns ILD exposed to the etching holes ETH may be removed to form dielectric regions HKR. The portions of the dielectric patterns ILD may be portions of the dielectric patterns ILD positioned on the second region R2 of the cell array region CAR. Residual portions of the dielectric patterns ILD on the first region R1 of the cell array region CAR, may be first sub-dielectric patterns ILD1a, and residual portions of the dielectric patterns ILD on the connection region CNR may be second dielectric patterns ILD2. The dielectric regions HKR may be empty spaces provided between the electrode patterns EL that are vertically adjacent to each other on the second region R2 of the cell array region CAR, and may expose portions of the sidewalls of the stack structure ST.

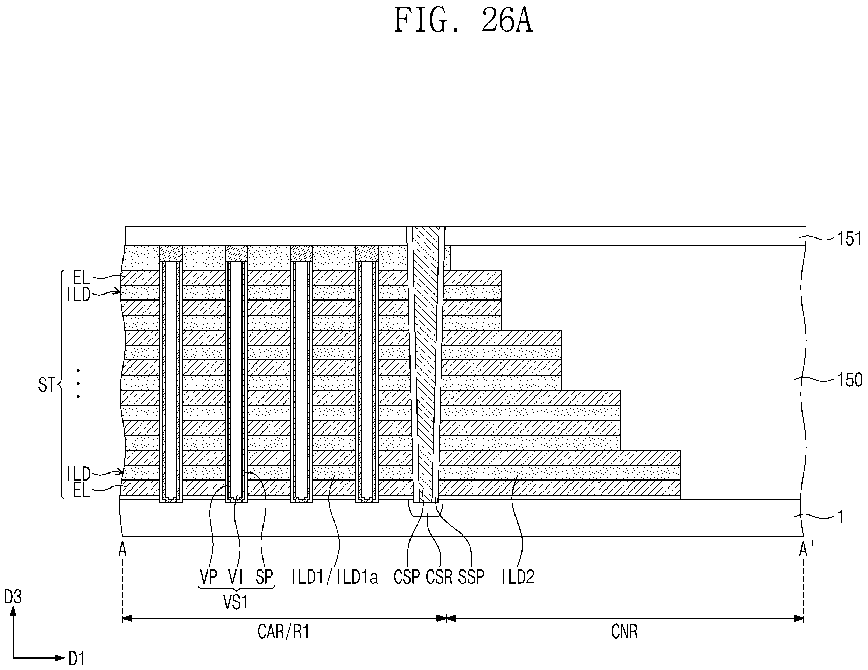

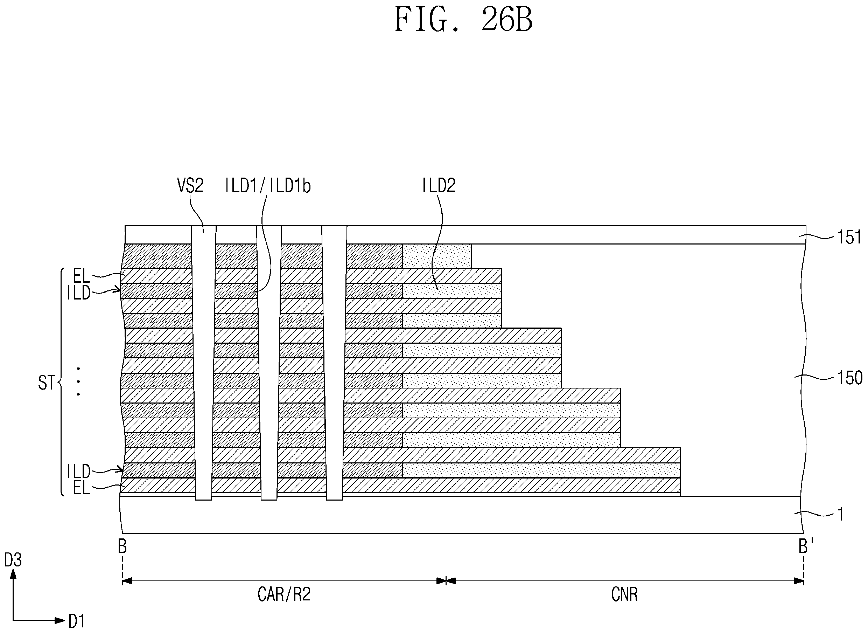

Referring to FIGS. 9, 26A, and 26B, second sub-dielectric patterns ILDlb may be formed in the dielectric regions HKR. For example, the second sub-dielectric patterns ILD1b may be formed by allowing a dielectric material to fill the dielectric regions HKR, and anisotropically etching the dielectric material deposited on inner walls of the etching holes ETH. The dielectric material may include a high-k dielectric material. After the formation of the second dielectric patterns ILD2, second vertical structures VS2 may be formed in the etching holes ETH.

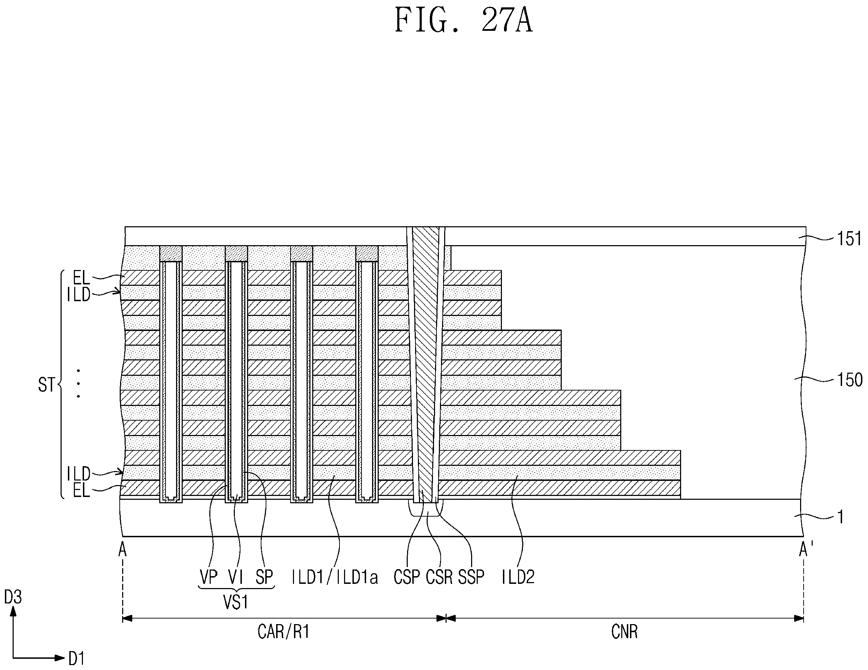

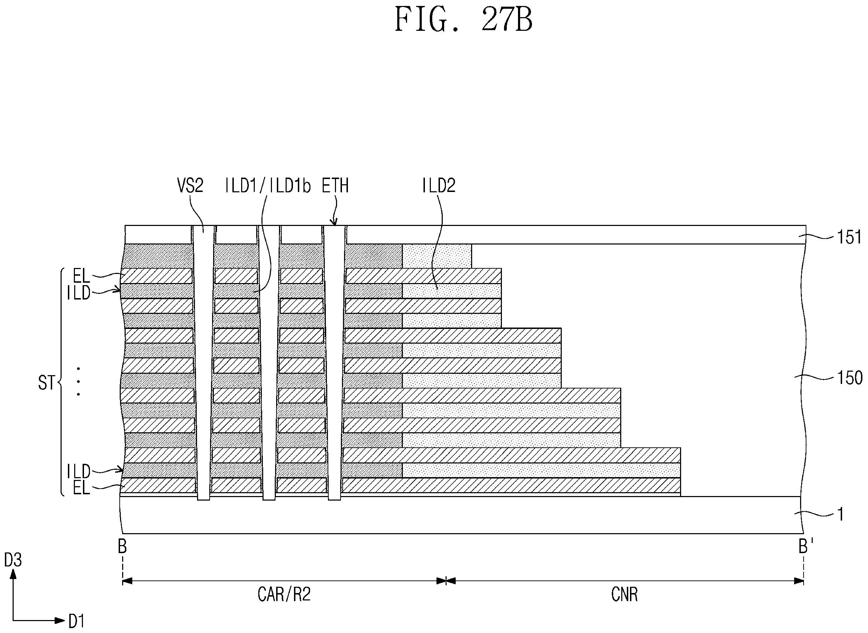

According to some example embodiments, there may be no removal of the dielectric material deposited on the inner walls of the etching holes ETH. As shown in FIGS. 9, 27A, and 27B, in this case, the dielectric material may cover sidewalls of the electrode patterns EL in the stack structure ST. Afterwards, second vertical structures VS2 may be formed in the etching holes ETH. Thus, the dielectric material may separate the second vertical structure VS2 from the electrode patterns EL. This case may fabricate a semiconductor device discussed with reference to FIG. 13.

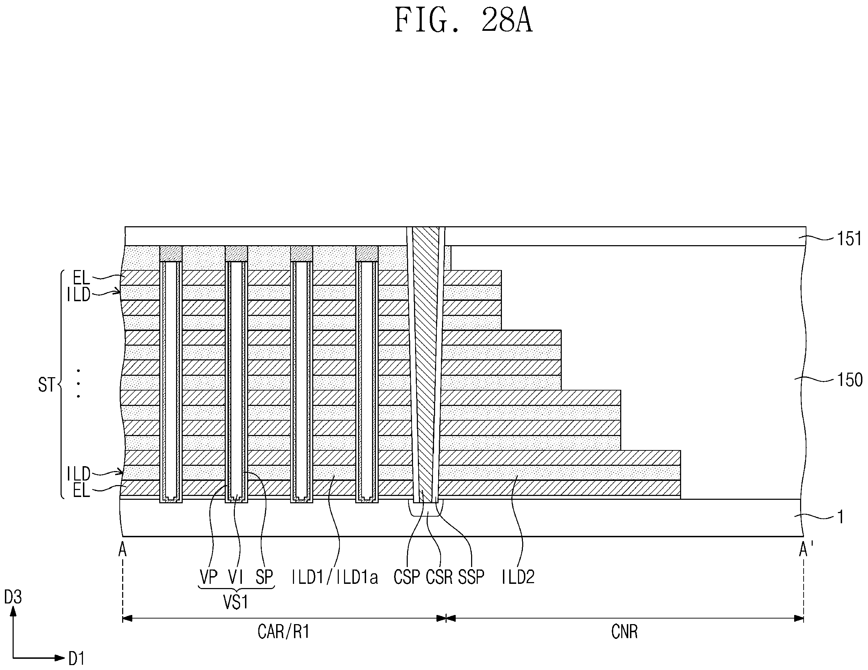

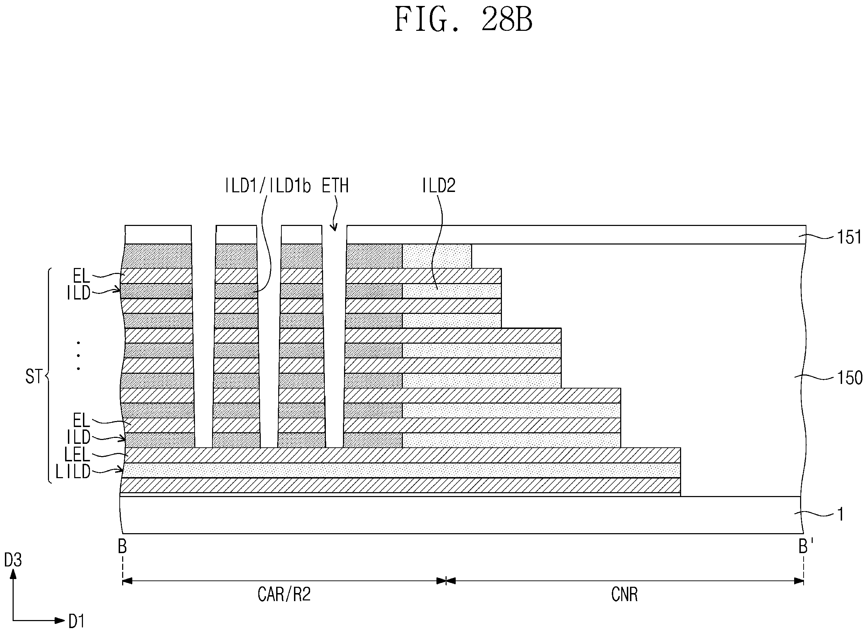

According to some example embodiments, as shown in FIGS. 9, 28A, and 28B, on a resultant structure of FIGS. 24A and 24B, etching holes ETH may be formed to penetrate the stack structure ST on the second region R2 of the cell array region CAR. The etching holes ETH may not completely penetrate the stack structure ST. For example, the etching holes ETH may penetrate the electrode patterns EL and the dielectric patterns ILD of the stack structure ST, but may not penetrate a lower electrode pattern LEL and a lower dielectric pattern LILD of the stack structure ST. The lower electrode pattern LEL may indicate a lowermost one of the electrode patterns EL, and the lower dielectric pattern LILD may indicate a lowermost one of first dielectric patterns ILD1 or a plurality of the lowermost ones of the first dielectric patterns ILD 1. The etching holes ETH may expose a top surface of the lower electrode pattern LEL and may not be in contact with the lower dielectric pattern LILD. The etching holes ETH may be formed by anisotropically etching the stack structure ST, and may expose sidewalls of the stack structure ST.

On the second region R2 of the cell array region CAR, portions of the dielectric patterns ILD exposed to the etching holes ETH may be removed to form dielectric regions. The portions of the dielectric patterns ILD may be portions of the dielectric patterns ILD positioned on the second region R2 of the cell array region CAR. The dielectric regions may be empty spaces provided between the electrode patterns EL that are vertically adjacent to each other on the second region R2 of the cell array region CAR, and may expose portions of the sidewalls of the stack structure ST.

Second sub-dielectric patterns ILDlb may be formed in the dielectric regions. For example, the second sub-dielectric patterns ILDlb may be formed by allowing a dielectric material to fill the dielectric regions, and anisotropically etching the dielectric material deposited on inner walls of the etching holes ETH.

After the formation of the second dielectric patterns ILD2, second vertical structures VS2 may be formed in the etching holes ETH. This case may fabricate a semiconductor device discussed with reference to FIG. 15. The following description will relate to the example embodiments of FIGS. 26A and 26B.

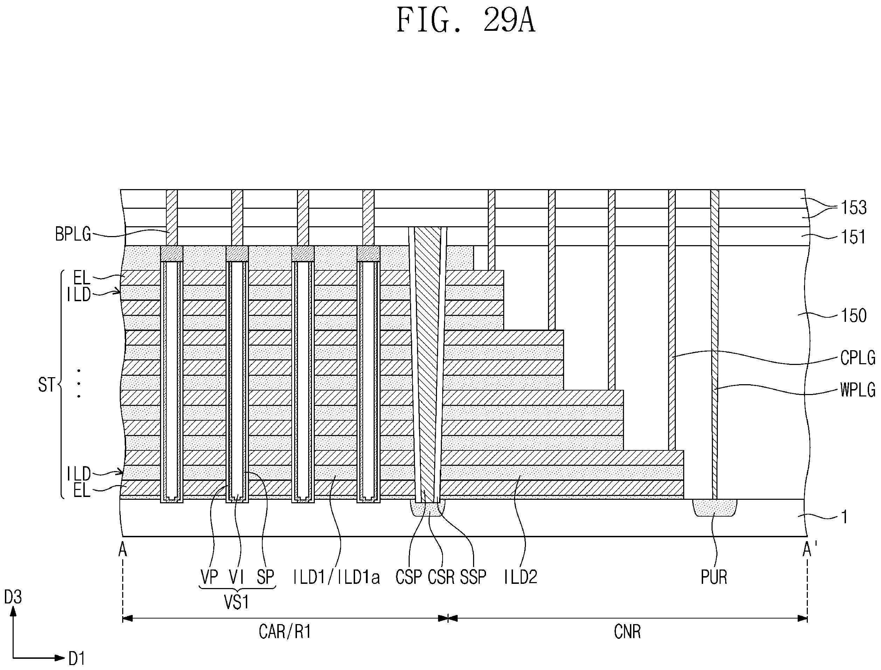

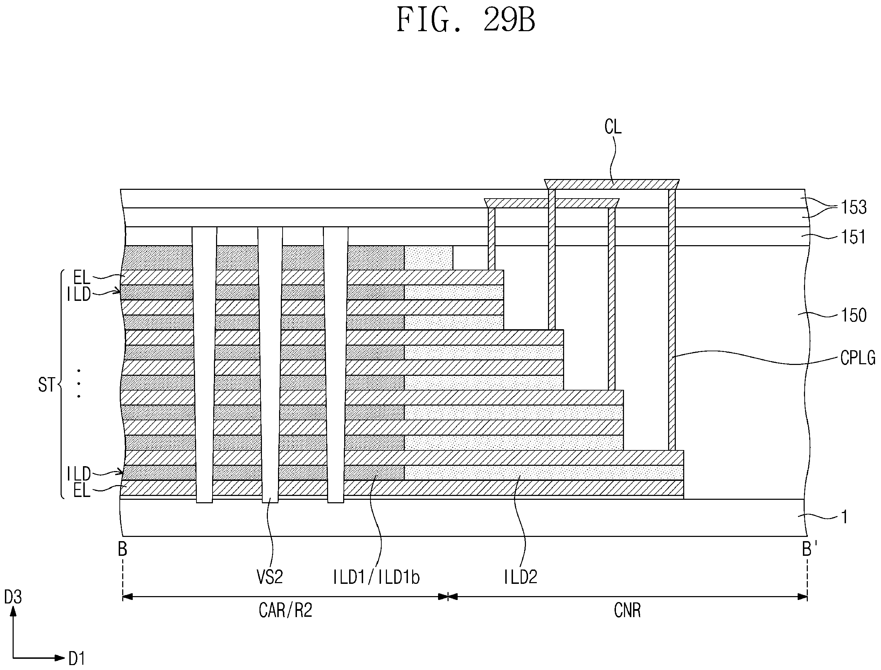

Referring to FIGS. 9, 29A, and 29B, a second interlayer dielectric layer 153 may be formed on the first interlayer dielectric layer 151. Thereafter, the second interlayer dielectric layer 153, the first interlayer dielectric layer 151, and the first buried dielectric layer 150 may undergo a patterning process to form contact holes. The contact holes may correspondingly expose ends of the electrode patterns EL on the connection region CNR. The contact holes may be filled with a conductive material to form cell contact plugs CPLG.

Connection lines CL may be formed on the second interlayer dielectric layer 153. For example, a conductive layer may be formed on the second interlayer dielectric layer 153, and then the conductive layer may be patterned to form the connection lines CL. The connection lines CL may connect the cell contact plugs CPLG to each other.

Another second interlayer dielectric layer 153 may be formed on the second interlayer dielectric layer 153. After that, the second interlayer dielectric layers 153, the first interlayer dielectric layer 151, and the first buried dielectric layer 150 may undergo a patterning process to form contact holes. The contact holes may correspondingly expose ends of the electrode patterns EL on the connection region CNR. Connection contact holes may be spaced apart from the stack structure ST, while exposing the first substrate 1. Bit-line contact holes may expose the first vertical structures VS1 on the cell array region CAR. The contact holes may be filled with a conductive material to form bit-line contact plugs BPLG, cell contact plugs CPLG, and well contact plugs WPLG.

Referring back to FIGS. 9, 10A, and 10B, on the second interlayer dielectric layer 153, a cell array wiring layer 160 may be formed to include bit lines BL, connection lines CL, and peripheral connection lines PCL discussed above.

A third interlayer dielectric layer 155 may be formed on the second interlayer dielectric layers 153. The third interlayer dielectric layer 155 may expose top surfaces of the bit lines BL, top surfaces of the connection lines CL, and top surfaces of the peripheral connection lines PCL. Through the processes mentioned above, a cell array structure CS may be formed.

In a semiconductor device according to some example embodiments of the present inventive concept, among dielectric patterns on a cell array region, dielectric patterns on a second region on which no memory cells are provided may be used to provide a capacitor. Therefore, no separate zone for providing the capacitor may be desirable or needed, and the semiconductor device may decrease in size.

In addition, on a first region of the cell array region, low-k dielectric patterns may be provided between electrode patterns that are gate electrodes of memory cells. Thus, parasitic capacitance or tunneling may occur less frequently between the gate electrodes. Moreover, on the second region of the cell array region, high-k dielectric patterns may be provided between electrode patterns that are capacitor electrodes. It may therefore be possible to provide capacitors whose capacitance is high. As a result, the semiconductor device may increase in electrical properties.

When the terms "about" or "substantially" are used in this specification in connection with a numerical value, it is intended that the associated numerical value includes a manufacturing or operational tolerance (e.g., ±10 %) around the stated numerical value. Moreover, when the words "generally" and "substantially" are used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10 %) around the stated numerical values or shapes.

As described herein, any electronic devices and/or portions thereof according to any of the example embodiments may include, may be included in, and/or may be implemented by one or more instances of processing circuitry such as hardware including logic circuits; a hardware/software combination such as a processor executing software; or any combination thereof. For example, the processing circuitry more specifically may include, but is not limited to, a central processing unit (CPU), an arithmetic logic unit (ALU), a graphics processing unit (GPU), an application processor (AP), a digital signal processor (DSP), a microcomputer, a field programmable gate array (FPGA), and programmable logic unit, a microprocessor, application-specific integrated circuit (ASIC), a neural network processing unit (NPU), an Electronic Control Unit (ECU), an Image Signal Processor (ISP), and the like. In some example embodiments, the processing circuitry may include a non-transitory computer readable storage device (e.g., a memory), for example a DRAM device, storing a program of instructions, and a processor (e.g., CPU) configured to execute the program of instructions to implement the functionality and/or methods performed by some or all of any devices, systems, modules, units, controllers, circuits, architectures, and/or portions thereof according to any of the example embodiments, and/or any portions thereof.

We addition describe devices as below:
- A semiconductor device may include a substrate that includes a cell array region and a connection region positioned in a first direction from the cell array region, wherein the cell array region has a first region and a second region positioned in a second direction from the first region, the second direction being orthogonal to the first direction; a stack structure that includes electrode patterns that are vertically stacked on the substrate, first dielectric patterns between the electrode patterns on the first region, and second dielectric patterns between the electrode patterns on the second region, an end in the first direction of the stack structure having a stepwise structure; a plurality of channels that vertically penetrate the stack structure on the first region; a plurality of vertical structures that vertically penetrate the stack structure on the second region; a planarized dielectric layer that covers the stack structure; a plurality of through plugs on the connection region, the through plugs penetrating the planarized dielectric layer and being connected to the electrode patterns; and a plurality of wiring patterns on the planarized dielectric layer, each of the wiring patterns connecting two of the through plugs to each other. The first dielectric patterns may include a material different from a material of the second dielectric patterns.
- An electronic system may include a semiconductor device that includes a substrate including a cell array region and a connection region, a stack structure including electrode patterns vertically and alternately stacked on the substrate and having a stepwise structure on the connection region, a plurality of channels that vertically penetrate the stack structure on the cell array region, a planarized dielectric layer that covers the stack structure, and an input/output pad electrically connected to a peripheral circuit; and a controller electrically connected through the input/output pad to the semiconductor device, the controller controlling the semiconductor device. A plurality of first dielectric patterns may be correspondingly provided between the electrode patterns on a first region of the cell array region. A plurality of second dielectric patterns may be correspondingly provided between the electrode patterns on a second region of the cell array region. A plurality of third dielectric patterns may be correspondingly provided between the electrode patterns on the connection region. The second dielectric patterns may include a material different from a material of the first dielectric patterns and different from a material of the third dielectric patterns. Each of the second dielectric patterns may be horizontally connected to one of the third dielectric patterns. Interfaces between the second dielectric patterns and the third dielectric patterns may become farther away in a direction as the interfaces approach closer to the substrate. The direction may be directed from the connection region toward the cell array region.
- A method of fabricating a semiconductor device may include providing a substrate that has a cell array region and a connection region; forming on the substrate a thin-layer structure in which sacrificial layers and dielectric layers are alternately stacked; performing a trimming process on the thin-layer structure that has a stepwise structure on the connection region; forming a buried dielectric layer that covers the thin-layer structure on the substrate; forming a plurality of first vertical holes that vertically penetrate the thin-layer structure on the cell array region; using the first vertical holes to replace the sacrificial layers of the thin-layer structure with a plurality of electrodes; forming a plurality of channels that vertically penetrate the thin-layer structure on a first region of the cell array region; forming a plurality of second vertical holes that vertically penetrate the thin-layer structure on a second region of the cell array region; using the second vertical holes to replace portions of the dielectric layers on the second region with a plurality of high-k dielectric patterns; and forming on the connection region a plurality of through plugs that vertically penetrate the buried dielectric layer and are connected to ends of the electrodes.

Although the present disclosure describes example embodiments of the present inventive concept illustrated in the accompanying drawings, it will be understood by one of ordinary skill in the art that variations in form and detail may be made therein without departing from the the present invention which is defined by the claims. The above disclosed example embodiments should thus be considered illustrative and not restrictive.

## Claims

1. A semiconductor device, comprising:
a substrate including a first region and a second region in a first direction from the first region;
a stack structure including electrode patterns and dielectric patterns vertically and alternately stacked on the substrate;
a plurality of channels vertically penetrating the stack structure on the first region;
a planarized dielectric layer covering the stack structure; and
a plurality of wiring patterns on the planarized dielectric layer,
each of the dielectric patterns including
a first dielectric pattern on the first region; and
a second dielectric pattern on the second region,
each of the second dielectric patterns including
a first sub-dielectric pattern; and
a second sub-dielectric pattern connected in a second direction to the first sub-dielectric pattern, the second direction intersecting the first direction,
wherein a dielectric constant of the first sub-dielectric patterns is greater than a dielectric constant of the first dielectric patterns and a dielectric constant of the second sub-dielectric patterns.

2. The semiconductor device of claim 1, wherein the first dielectric patterns and the second sub-dielectric patterns include a same material.

3. The semiconductor device of claim 2, wherein
the first dielectric patterns and the second sub-dielectric patterns include silicon oxide (SiO), and
the first sub-dielectric patterns include aluminum oxide (Al₂O₃), titanium oxide (TiO₂), zirconium oxide (ZrOz), and/or hafnium oxide (HfO₂).

4. The semiconductor device of any preceding claim, wherein interfaces between the first sub-dielectric patterns and the second sub-dielectric patterns are perpendicular to a top surface of the substrate.

5. The semiconductor device of any preceding claim, wherein interfaces between the first sub-dielectric patterns and the second sub-dielectric patterns are bent in the second direction.

6. The semiconductor device of any preceding claim, wherein interfaces between the first sub-dielectric patterns and the second sub-dielectric patterns become farther away in a direction opposite to the second direction as the interfaces approach closer to the substrate.

7. The semiconductor device of any preceding claim, wherein
the substrate includes a cell array region and a connection region in the second direction from the cell array region, wherein the stack structure has a stepwise structure on the connection region,
the semiconductor device further comprises a plurality of through plugs on the connection region, the through plugs penetrating the planarized dielectric layer and being connected to the electrode patterns, and
each of the wiring patterns connects two of the through plugs to each other.

8. The semiconductor device of claim 7, comprising a capacitor constituted by two of the electrode patterns and the dielectric patterns that are between the two of the electrode patterns, the two of the electrode patterns being connected to two of the through plugs.

9. The semiconductor device of claim 7 or 8, further comprising a plurality of vertical structures on the second region, the vertical structures vertically penetrating the stack structure on the connection region,
wherein the vertical structures are in contact with lateral surfaces of the first sub-dielectric patterns.

10. The semiconductor device of any preceding claim, wherein
a lowermost one of the second dielectric patterns includes the first sub-dielectric pattern and does not include the second sub-dielectric pattern, and
the first sub-dielectric pattern of the lowermost second dielectric pattern extends below the second sub-dielectric pattern of another second dielectric pattern on the lowermost second dielectric pattern.

11. The semiconductor device of claim 10, further comprising a plurality of vertical structures vertically penetrating the stack structure on the second region,
wherein the vertical structures are above the lowermost second dielectric pattern.
